# EUROPEAN PATENT SPECIFICATION

(11) **EP 1 134 759 B1**
(45) Date of publication and mention of the grant of the patent: **22.08.2007**
(21) Application number: 01106168.6
(22) Date of filing: 13.03.2001
(51) Int. Cl.: H01G 9/20, H01M 14/00, H01M 10/40

(54) **Electrolyte composition for photo-electrochemical cells**
Elektrolytzusammensetzung für photoelektrochemische Zellen
Composition d'électrolyte pour des cellules photoélectrochimiques

(30) Priority: 16.03.2000 JP 2000074855
(43) Date of publication of application: 19.09.2001
(73) Proprietor: FUJIFILM Corporation, Minato-ku Tokyo (JP)
(72) Inventor: Wariishi, Koji, c/oFuji Photo Film Co. Ltd., Minami-Ashigara-shi, Kanagawa-ken (JP); Qian, Chang-yi, c/oFuji Photo Film Co. Ltd., Minami-Ashigara-shi, Kanagawa-ken (JP)
(74) Representative: Patentanwälte Dr. Solf & Zapf

(56) References cited:
- EP-A- 0 155 155
- EP-A- 0 924 724
- EP-A- 0 980 082
- EP-A- 0 986 079
- WO-A-92/15198
- DE-B- 1 231 701
- JP-A- 59 223 372
- SU-A- 1 493 646
- US-A- 3 898 257
- US-A- 5 232 964
- US-A- 5 962 188
- PATENT ABSTRACTS OF JAPAN vol. 1996, no. 11, 29 November 1996 (1996-11-29) -& JP 08 194330 A (FUJI XEROX CO LTD), 30 July 1996 (1996-07-30)
- PATENT ABSTRACTS OF JAPAN vol. 013, no. 536 (C-660), 29 November 1989 (1989-11-29) -& JP 01 221455 A (SHIN ETSU CHEM CO LTD), 4 September 1989 (1989-09-04)
- DENG S-M ET AL: "Formation of polyelectrolyte complexes based on pendant type imidazolium organosilicon polymer with poly(sodium styrene sulfonate)" POLYMER, ELSEVIER SCIENCE PUBLISHERS B.V, GB, vol. 39, no. 23, 1 November 1998 (1998-11-01), pages 5643-5648, XP004129146 ISSN: 0032-3861
- PATENT ABSTRACTS OF JAPAN vol. 2000, no. 05, 14 September 2000 (2000-09-14) & JP 2000 058140 A (FUJI PHOTO FILM CO LTD), 25 February 2000 (2000-02-25)

## Description

### BACKGROUND OF THE INVENTION

The present invention relates to an electrolyte composition excellent in durability and charge-transporting capability, a photoelectric conversion device comprising the electrolyte composition, and a photo-electrochemical cell composed of the photoelectric conversion device. The present invention also relates to an imidazolium compound and a pyridinium compound, which is usable for the electrolyte composition.

Conventionally, an electrolysis solution comprising a solvent and an electrolyte salt dissolved therein has been used as an electrolyte composition for electrochemical devices such as a cell, a capacitor, a sensor, a display device, a recording device, etc. However, the electrochemical devices using such an electrolysis solution are unreliable because they often cause leakage of the electrolysis solution during long-term operation or storage.

Nature, Vol. 353, page 737 to 740 (1991), United States Patent No. 4,927,721, etc. disclosed photoelectric conversion devices utilizing dye-sensitized semiconductor particles, and photo-electrochemical cells composed thereof. However, the photoelectric conversion devices also comprise the electrolysis solution in a charge transfer layer, so that there is still a fear that their photoelectric conversion efficiency is extremely lowered, or their photoelectric conversion function is lost by leakage or depletion of the electrolysis solution during the long-term operation or storage.

Under these circumstances, International Patent No. 93/20565 disclosed a photoelectric conversion device comprising a solid electrolyte. Further, Nippon Kagaku Kaishi, 7, 484 (1997), Japanese Patent Laid-Open No. 7-288142, Solid State Ionics, 89, 263 (1986) and Japanese Patent Laid-Open No. 9-27352 proposed a photoelectric conversion device using a solid electrolyte comprising a cross-linked, poly(ethylene oxide)-based polymer. However, the devices using the solid electrolyte are insufficient in photoelectric conversion characteristics, especially short-circuit current density, and durability.

Further, disclosed in WO 95/18456, Japanese Patent Laid-Open No. 8-259543, Denki Kagaku, 65, 11, 923 (1997), etc. are photoelectric conversion devices comprising an electrolyte composition in which a pyridinium salt, an imidazolium salt, a triazolium salt, etc. is used as the electrolyte to prevent the leakage and depletion of the electrolyte composition. The salts are liquid at room temperature, called as "room temperature molten salt". In such electrolyte composition, a solvent for dissolving the electrolyte such as water and organic solvents is not necessary or needed only a little amount, whereby the photoelectric conversion devices comprising the composition exhibit improved durability.

In addition, EP 0 980 082 A2 discloses an electrolyte containing a 5- or 6-membered nitrogen-containing aromatic ring compound having a specific structure represented by formula (I) or (I') and a photo-electrochemical cell having the electrolyte. The electrolyte hardly volatilizes and performs an excellent charge transport function to provide a photoelectrochemical cell having excellent photoelectric characteristics and durability. 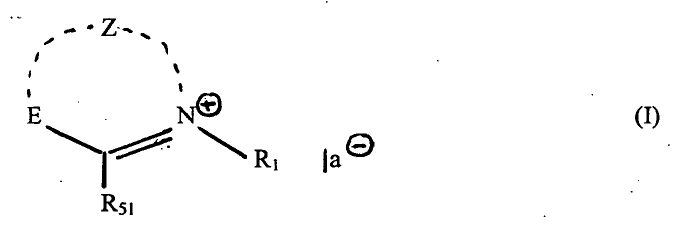 wherein Z represents an atomic group necessary to form a 5-membered aromatic ring cation together with the nitrogen atom and E; E represents an oxygen atom or a sulphur atom; R₁ represents an alkyl group or an alkenyl group; R₅₁ represents a hydrogen atom or a substituent; and a represents 1 or 3.

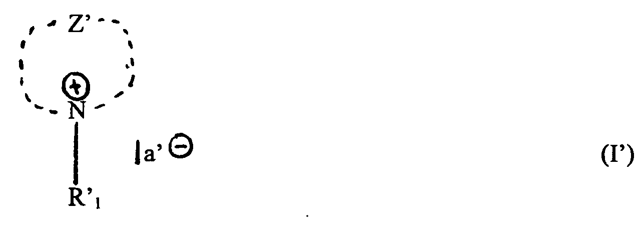

Wherein Z' represents an atomic group necessary to form a 6-membered aromatic ring cation together with the nitrogen atom; R₁ represents an alkyl group or an alkenyl group; and a' represents 1 or 3.

DENG S-M et al: "Formation of polyelectrolyte complexes based on pendant type imidazolium organosilicon polymer with poly(sodium styrene sulfonate)" POLYMER, ELSEVIER SCIENCE PUBLISHERS B.V., GB, vol. 39, no. 23, 1 November 1998 (1998-11-01), pages 5643-5648, XP004129146 ISSN: 0032-3861 describes an imidazolium substituent grafted on a polysiloxane chain and describes the use thereof as polyelectrolyte complexes. However, it fails to describe the use of the mentioned compounds in an electrolyte composition for a photo-electrochemical cell.

However, the devices using the room temperature molten salt generally has such a defect as insufficient photoelectric conversion efficiency.

### OBJECT AND SUMMARY OF THE INVENTION

Accordingly, an object of the present invention is to provide an electrolyte composition excellent in durability and charge-transporting capability, a photoelectric conversion device that comprises the electrolyte composition to exhibits high durability and excellent photoelectric conversion properties, and a photo-electrochemical cell composed of the photoelectric conversion device.

Another object of the present invention is to provide novel imidazolium compound and pyridinium compound, which is usable for the electrolyte composition.

As a result of intense research in view of the above object, the inventor has found that an electrolyte composition comprising a compound represented by the following general formula (1) is excellent in the durability and charge-transporting capability. The present invention has been accomplished by the finding. 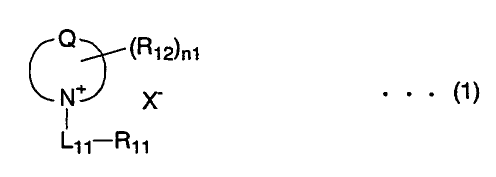 wherein Q represents an atomic group forming an aromatic cation having a 5- or 6-membered ring structure with a nitrogen atom; L₁₁ represents a divalent linking group selected from the group consisting of a substituted or unsubstituted alkylene group, a substituted or unsubstituted alkenylene group, a substituted or unsubstituted alkylenoxy group, a substituted or unsubstituted alkenylenoxy group, and a repetition or combination thereof; R₁₁ represents a hydrogen atom or a substituent; R₁₂ represents a substituent; n1 represents 0 or an integer of 1 to the maximum number of R₁₂ attachable to Q; X⁻ represents an anion; R₁₂'s may be the same or different groups when n1 is 2 or more; two or more of R₁₁ and R₁₂ may be bonded together to form a ring; and at least one of R₁₁ and R₁₂ contains a silicon atom.

A photoelectric conversion device of the present invention has an electrically conductive layer, a photosensitive layer, a charge transfer layer and a counter electrode, wherein the charge transfer layer comprises the electrolyte composition of the present invention. The photoelectric conversion device exhibits high durability and excellent photoelectric conversion properties.

A photo-electrochemical cell of the present invention is composed of the photoelectric conversion device.

With respect to the electrolyte composition, the photoelectric conversion device and the photo-electrochemical cell of the present invention, the durability, the charge-transporting capability and the photoelectric conversion properties are further improved by satisfying any of the following conditions (1) to (7).
(1) Q is preferably composed of atoms selected from the group consisting of carbon, hydrogen, nitrogen, oxygen and sulfur atoms.
(2) The aromatic cation formed by Q is particularly preferably an imidazolium cation or a pyridinium cation.
(3) It is preferable that the compound represented by the general formula (1) is further represented by the following general formula (2) or (3): 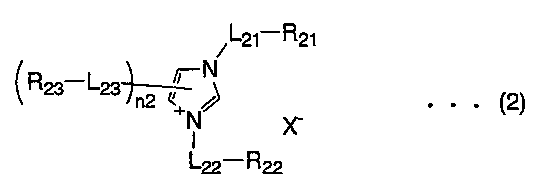 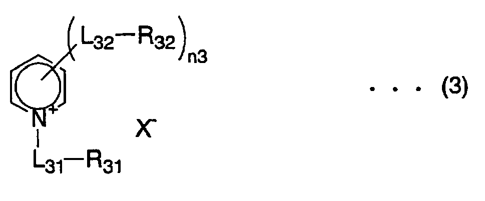
   In the general formula (2), L₂₁, L₂₂ and L₂₃ independently represent a divalent linking group selected from the group consisting of a substituted or unsubstituted alkylene group, a substituted or unsubstituted alkenylene group, a substituted or unsubstituted alkylenoxy group, a substituted or unsubstituted alkenylenoxy group, and a repetition or combination thereof; R₂₁, R₂₂ and R₂₃ independently represent a hydrogen atom or a substituent; n2 represents an integer of 0 to 3; X⁻ represents an anion; a plurality of L₂₃-R₂₃ may be the same or different groups when n2 is 2 or 3; two or more of R₂₁, R₂₂ and R₂₃ may be bonded together to form a ring; and at least one of R₂₁, R₂₂ and R₂₃ contains a silicon atom.
   In the general formula (3), L₃₁ and L₃₂ independently represent a divalent linking group selected from the group consisting of a substituted or unsubstituted alkylene group, a substituted or unsubstituted alkenylene group, a substituted or unsubstituted alkylenoxy group, a substituted or unsubstituted alkenylenoxy group, and a repetition or combination thereof; R₃₁ and R₃₂ independently represent a hydrogen atom or a substituent; n3 represents an integer of 0 to 5, X⁻ represents an anion; a plurality of L₃₂-R₃₂ may be the same or different groups when n3 is 2 or more; two or more of R₃₁ and R₃₂ may be bonded together to form a ring; and at least one of R₃₁ and R₃₂ contains a silicon atom.
(4) X⁻ is particularly preferably I⁻.
(5) The electrolyte composition preferably comprises a solvent of 0 to 10 weight % based on the entire electrolyte composition.
(6) The electrolyte composition preferably comprises an iodine salt and/or iodine in addition to the compound represented by the general formula (1).
(7) The photosensitive layer of the photoelectric conversion device preferably comprises semiconductor fine particles sensitized by a dye. The semiconductor fine particles are preferably metal chalcogenide fine particles, and the metal chalcogenide fine particles preferably contain titanium oxide fine particles. The dye is preferably a metal complex dye and/or a polymethine dye.

A imidazolium compound represented by the following general formula (4) and a pyridinium compound represented by the following general formula (5) can be preferably used for the electrolyte composition according to the present invention.

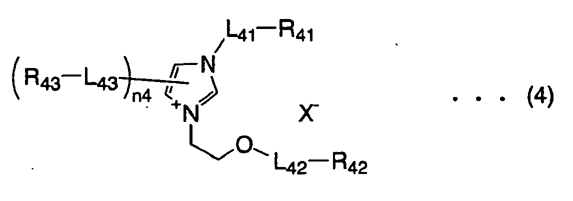

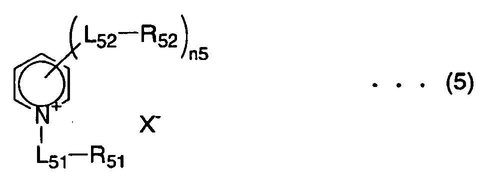

In the general formula (4), L₄₁, L₄₂ and L₄₃ independently represent a divalent linking group selected from the group consisting of a substituted or unsubstituted alkylene group, a substituted or unsubstituted alkenylene group, a substituted or unsubstituted alkylenoxy group, a substituted or unsubstituted alkenylenoxy group, and a repetition or combination thereof; R₄₁, R₄₂ and R₄₃ independently represent a hydrogen atom, a halogen atom or a substituent selected from the group consisting of an alkyl group, an alkenyl group, an aryl group, a silyl group, a silyloxy group, an alkoxy group, an amino group, a guanidino group, a cyano group and a heterocyclic group, which may have another substituent; n4 represents an integer of 0 to 3; X⁻ represents an anion; a plurality of L₄₃-R₄₃ may be the same or different groups when n4 is 2 or 3;two or more of R₄₁, R₄₂ and R₄₃ may be bonded together to form a ring; and at least one of R₄₁, R₄₂ and R₄₃ contains a silicon atom.

In the general formula (5), L₅₁ and L₅₂ independently represent a divalent linking group selected from the group consisting of a substituted or unsubstituted alkylene group, a substituted or unsubstituted alkenylene group, a substituted or unsubstituted alkylenoxy group, a substituted or unsubstituted alkenylenoxy group, and a repetition or combination thereof; R₅₁ and R₅₂ independently represent a hydrogen atom, a halogen atom or a substituent selected from the group consisting of an alkyl group, an alkenyl group, an aryl group, a silyl group, a silyloxy group, an alkoxy group, an amino group, a guanidino group, a cyano group and a heterocyclic group, which may have another substituent; n5 represents an integer of 0 to 5; X⁻ represents an anion; a plurality of L₅₂-R₅₂ may be the same or different groups when n5 is 2 or more; two or more of R₅₁ and R₅₂ may be bonded together to form a ring; and at least one of R₅₁ and R₅₂ contains a silicon atom.

### BRIEF DESCRIPTION OF THE DRAWINGS

Fig. 1 is a partial cross sectional view showing a preferable structure of a photoelectric conversion device of the present invention,
Fig. 2 is a partial cross sectional view showing a preferable structure of a photoelectric conversion device of the present invention,
Fig. 3 is a partial cross sectional view showing a preferable structure of a photoelectric conversion device of the present invention,
Fig. 4 is a partial cross sectional view showing a preferable structure of a photoelectric conversion device of the present invention,
Fig. 5 is a partial cross sectional view showing a preferable structure of a photoelectric conversion device of the present invention,
Fig. 6 is a partial cross sectional view showing a preferable structure of a photoelectric conversion device of the present invention,
Fig. 7 is a partial cross sectional view showing a preferable structure of a photoelectric conversion device of the present invention,
Fig. 8 is a partial cross sectional view showing a preferable structure of a photoelectric conversion device of the present invention, and
Fig. 9 is a partial cross sectional view showing an example of a structure of a substrate-integrated type solar cell module comprising a photoelectric conversion device of the present invention.

### DETAILED DESCRIPTION OF THE PREFERRED EMBODIMENTS

### [1] Electrolyte Composition

An electrolyte composition according to the present invention is usable for a solvent for chemical reactions, metal plating, etc., a CCD (charge coupling device) camera, various kinds of photoelectric conversion devices or cells, etc. The composition is preferably used for a lithium ion secondary batteries or a photo-electrochemical cell, particularly those comprising semiconductor. The constitutive elements of the electrolyte composition will be described in detail below.

### (A) Compound Represented by the General Formula (1)

The electrolyte composition of the present invention comprises a compound represented by the following general formula (1): 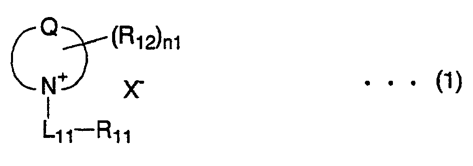 The compound represented by the general formula (1) is preferably a salt having a low melting point, a so-called "molten salt", more preferably such that is liquid at room temperature (around 25 ° C), a so-called "room temperature-molten salt". The melting point of this compound is preferably 100 °C or less, more preferably 80 ° C or less, particularly preferably 60 ° C or less.

The compound represented by the general formula (1) can be generally used as the electrolyte with little or no solvent. Even if the compound is solid at room temperature, the compound is liquefied by adding a little amount of solvent or additive thereto, to be used as the electrolyte. Alternatively, the compound can be incorporated in the photoelectric conversion device without any additives by: a method where the compound is heat-dissolved and penetrates into an electrode of the device; a method comprising the steps of dissolving the compound in a low boiling solvent such as methanol, acetonitrile and methylene chloride, making the resultant solution penetrate into an electrode, and evaporating the solvent by heating; etc.

In the general formula (1), Q represents an atomic group forming an aromatic cation having a 5- or 6-membered ring structure with a nitrogen atom. Q is preferably composed of atoms selected from the group consisting of carbon, hydrogen, nitrogen, oxygen and sulfur atoms. As for the 5-membered ring formed by Q, preferred are such rings as an oxazole ring, a thiazole ring, an imidazole ring, a pyrazole ring, an iso-oxazole ring, a thiadiazole ring, an oxadiazole ring and a triazole ring. The 5-membered ring is more preferably a thiazole ring, an imidazole ring or a triazole ring, particularly preferably an imidazole ring. As for the 6-membered ring formed by Q, preferred are such rings as a pyridine ring, a pyrimidine ring, a pyridazine ring, a pyrazine ring and a triazine ring. The 6-membered ring is particularly preferably a pyridine ring.

In the general formula (1), L₁₁ represents a divalent linking group selected from the group consisting of a substituted or unsubstituted alkylene group, a substituted or unsubstituted alkenylene group, a substituted or unsubstituted alkylenoxy group, a substituted or unsubstituted alkenylenoxy group, and a repetition or combination thereof. Examples of L₁₁ include a methylene group, an ethylene group, a propylene group, a vinylene group, a propenylene group, -(CH₂CH₂O)ₙ-, -(CH₂CH₂O)ₙ-CH₂-, -(CH₂CH₂CH₂O)ₙ-,-(CH₂CH₂CH₂O)ₙ-CH₂-, -(CH(CH₃)CH₂O)ₙ-, -(CH₂CH(CH₃)O)ₙ-,-(CH(CH₃)CH₂O)ₙ-CH₂-, -(CH₂CH(CH₃)O)ₙ-CH₂-, a combination thereof. L₁₁ is preferably a methylene group, an ethylene group, a propylene group, - (CH₂CH₂O)ₙ-, -(CH₂CH₂O)ₙ-CH₂-, -(CH₂CH₂CH₂O)ₙ-, or -(CH₂CH₂CH₂O)ₙ-CH₂-. Incidentally, *n* is each an integer of 1 to 20.

In the general formula (1), R₁₁ represents a hydrogen atom or a substituent, and R₁₂ represents a substituent. Examples of the substituent represented by R₁₁ and R₁₂ include: an alkyl group such as a methyl group, an ethyl group, a propyl group, an isopropyl group, a cyclopropyl group, a butyl group, an octyl group, a 2-carboxyethyl group and a benzyl group; an alkenyl group such as a vinyl group, an allyl group and a propenyl group; an aryl group such as a phenyl group and a methoxyphenyl group; a substituted or unsubstituted silyl group preferably having 3 to 30 carbon atoms such as a trimethylsilyl group, a *t*-butyldimethylsilyl group, a phenyldimethylsilyl group and -(Si(CH₃)₂O)ₙSi(CH₃)₃; a silyloxy group preferably having 3 to 20 carbon atoms such as a trimethylsilyloxy group and a t-butyldimethylsilyloxy group; an alkoxy group such as a methoxy group, an ethoxy group,-(OCH₂CH₂)ₙ-OCH₃ and -(OCH₂CH₂)ₙ-OCH₂CH₃; an amino group such as a dimethylamino group and a diethylamino group; an amido group such as an acetylamino group and a benzoylamino group; a guanidino group; a carbamoyl group such as an *N,N-*dimethylcarbamoyl group and an *N*-phenylcarbamoyl group; a cyano group; an alkylthio group such as a methylthio group and an ethylthio group; a heterocyclic group such as a pyridyl group and an imidazolyl group; a halogen atom such as a chlorine atom, a bromine atom and an iodine atom; etc. Incidentally, *n* is each an integer of 1 to 20. Among them, preferred are an alkyl group, an alkenyl group, an aryl group, a silyl group, a silyloxy group, an alkoxy group, an amino group, a guanidino group, a cyano group, a heterocyclic group and a halogen atom. R₁₁ and R₁₂ may further have a substituent.

In the general formula (1), n1 indicating the number of R₁₂ is 0 or an integer of 1 to the maximum number of R₁₂ attachable to Q, preferably an integer of 0 to 2. R₁₂'s may be the same or different groups when n1 is 2 or more. Further, two or more of R₁₁ and R₁₂ may be bonded together to form a ring. The ring is preferably 5- to 7-membered ring, more preferably 5- or 6-membered ring. At least one of R₁₁ and R₁₂ contains a silicon atom.

The compound represented by the general formula (1) may form an oligomer (or polymer) through R₁₁ and/or R₁₂. The oligomer is preferably a dimer, a trimer or a tetramer, more preferably a dimer.

In the general formula (1), X⁻ represents an anion. Preferred examples of X⁻ include halide ions such as I⁻, Cl⁻ and Br⁻, N⁻(SO₂CF₃)₂, N⁻(SO₂CF₂CF₃)₂, C⁻(SO₂CF₃)₃, BF₄⁻, BPh₄⁻, SCN⁻, PF6₆⁻, ClO₄⁻, and an anion represented by the following general formula (6) or (7):

R₀₁-COO⁻ (6)

R₀₂-SO₃⁻ (7)

X⁻ is more preferably I⁻, N⁻(SO₂CF₃)₂, BF₄⁻, SCN⁻, or an anion represented by the general formula (6) or (7), particularly preferably I⁻.

In the general formula (6), R₀₁ is: a hydrogen atom; a perfluoroalkyl group preferably having 1 to 10 carbon atom such as a trifluoromethyl group, a pentafluoroethyl group and a heptafluoropropyl group; a substituted or unsubstituted alkyl group preferably having 1 to 10 carbon atom, which may be straight or branched, or cyclic, such as a methyl group, an ethylpropyl group, a butyl group, an isopropyl group, a pentyl group, a hexyl group, an octyl group, a 2-ethylhexyl group, a *t*-octyl group, a decyl group, a cyclohexyl group and a cyclopentyl group; or a substituted or unsubstituted aryl group preferably having 6 to 12 carbon atoms, such as a phenyl group, a tolyl group and a naphthyl group. R₀₁ is more preferably a perfluoroalkyl group having 1 to 10 carbon atom or an alkyl group having 1 to 10 carbon atom, particularly preferably a perfluoroalkyl group having 1 to 10 carbon atom.

In the case where R₀₁ is an alkyl group or an aryl group having a substituent, preferable examples of the substituent include a halogen atom, an alkoxy group, a cyano group, an alkoxycarbonyl group, a carbonate group, a silyl group, a silyloxy group, an amido group, a carbamoyl group, a phosphonyl group, a heterocyclic group, an alkylthio group, an acyl group, a sulfonyl group, an acyloxy group, a sulfonyloxy group, an aryl group, an aryloxy group, an alkenyl group, an alkyl group.

In the general formula (7), R₀₂ is: a perfluoroalkyl group preferably having 1 to 10 carbon atom such as a trifluoromethyl group, a pentafluoroethyl group and a heptafluoropropyl group; a substituted or unsubstituted alkyl group preferably having 1 to 10 carbon atom, which may be straight or branched, or cyclic, such as a methyl group, an ethylpropyl group, a butyl group, an isopropyl group, a pentyl group, a hexyl group, an octyl group, a 2-ethylhexyl group, a *t-*octyl group, a decyl group, a cyclohexyl group and a cyclopentyl group; or a substituted or unsubstituted aryl group preferably having 6 to 12 carbon atoms, such as a phenyl group, a tolyl group and a naphthyl group. R₀₂ is more preferably an alkyl group having 1 to 7 carbon atom, particularly preferably an alkyl group having 1 to 5 carbon atom. In the case where R₀₂ is an alkyl group or an aryl group having a substituent, preferable examples of the substituent are the same as those of the substituent on R₀₁ mentioned above.

The anion represented by the general formula (6) or (7) may form an oligomer (or polymer) through R₀₁ or R₀₂. The oligomer is preferably a dimer, a trimer or a tetramer, more preferably a dimmer.

It is preferable that the compound represented by the general formula (1) is further represented by the following general formula (2) or (3):

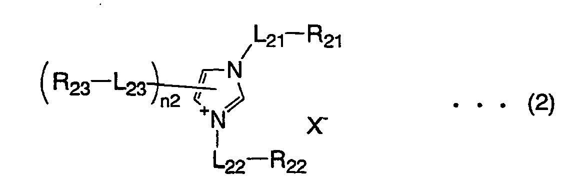

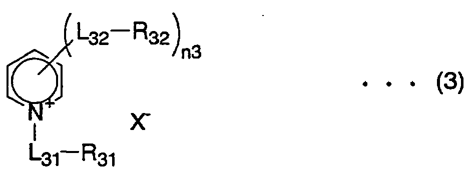

In the general formulae (2) and (3), L₂₁, L₂₂, L₂₃, L₃₁ and L₃₂ have the same meaning as L₁₁ mentioned above with preferred embodiments being the same as those of L₁₁. R₂₁, R₂₂, R₂₃, R₃₁ and R₃₂ have the same meaning as R₁₁ mentioned above with preferred embodiments being the same as those of R₁₁. n2 represents an integer of 0 to 3, and a plurality of L₂₃-R₂₃ may be the same or different groups when n2 is 2 or 3. n3 represents an integer of 0 to 5, and a plurality of L₃₂-R₃₂ may be the same or different groups when n3 is 2 or more. X⁻ in the general formulae (2) and (3) have the same meaning as X⁻ in the general formula (1) with preferred embodiments being the same as those thereof.

Two or more of R₂₁, R₂₂ and R₂₃ in the general formula (2), and two or more of R₃₁ and R₃₂ in the general formula (3) may be bonded together to form a ring, respectively. The ring is preferably 5- to 7-membered ring, more preferably 5- or 6-membered ring. Further, at least one of R₂₁, R₂₂ and R₂₃, and at least one of R₃₁ and R₃₂ contains a silicon atom, respectively.

The compound represented by the general formula (2) may form an oligomer (or polymer) through R₂₁, R₂₂, and/or R₂₃. The compound represented by the general formula (3) may also form an oligomer (or polymer) through R₃₁ and/or R₃₂. The oligomer is preferably a dimer, a trimer or a tetramer, more preferably a dimer.

A imidazolium compound represented by the following general formula (4) and a pyridinium compound represented by the following general formula (5) can be preferably used for the electrolyte composition according to the present invention.

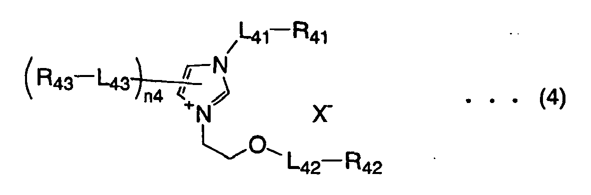

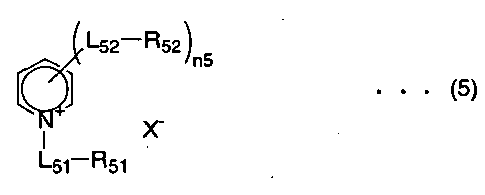

In the general formulae (4) and (5), L₄₁, L₄₂, L₄₃, L₅₁, and L₅₂ have the same meaning as L₁₁ mentioned above with preferred embodiments being the same as those of L₁₁. R₄₁, R₄₂, R₄₃, R₅₁ and R₅₂ independently represent a hydrogen atom, a halogen atom or a substituent selected from the group consisting of an alkyl group, an alkenyl group, an aryl group, a silyl group, a silyloxy group, an alkoxy group, an amino group, a guanidino group, a cyano group and a heterocyclic group. R₄₁, R₄₂, R₄₃, R₅₁, and R₅₂ may further have a substituent. n4 is an integer of 0 to 3, preferably 0 or 1, particularly preferably 0. A plurality of L₄₃-R₄₃ may be the same or different groups when n4 is 2 or 3. n5 is an integer of 0 to 5, preferably an integer of 0 to 2, particularly preferably 1. A plurality of L₅₂-R₅₂ may be the same or different groups when n5 is 2 or more. X⁻ in the general formulae (4) and (5) have the same meaning as X⁻ in the general formula (1) with preferred embodiments being the same as those thereof.

Two or more of R₄₁, R₄₂ and R₄₃ in the general formula (4), and two or more of R₅₁ and R₅₂ in the general formula (5) may be bonded together to form a ring, respectively. Further, at least one of R₄₁, R₄₂ and R₄₃, and at least one of R₅₁ and R₅₂ contains a silicon atom, respectively. The compound represented by the general formula (4) may form an oligomer (or polymer) through R₄₁, R₄₂, and/or R₄₃. The compound represented by the general formula (5) may also form an oligomer (or polymer) through R₅₁ and/or R₅₂.

Specific examples of the compound represented by the general formula (1) used in the present invention will be illustrated below without intention of restricting the scope of the present invention defined by the claims attached hereto.

| | | |
|---|---|---|
| 1 | 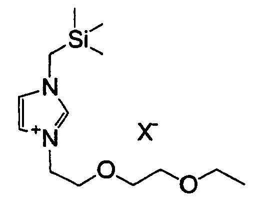 | 1-a : X=I⁻ |
| | | 1-b : X⁻=N⁻(SO₂CF₃)₂ |
| | | 1-c : X⁻=BF₄⁻ |
| | | 1-d : X⁻=SCN⁻ |
| | | 1-e : X⁻=CF₃COO⁻ |
| | | 1-f : X⁻=CH₃SO₃⁻ |
| 2 | 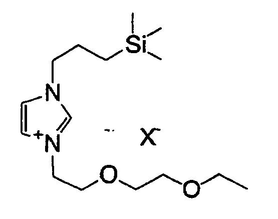 | 2-a : X⁻=l⁻ |
| | | 2-b : X⁻=N⁻(SO₂CF₃)2 |
| | | 2-c : X⁻=BF₄⁻ |
| | | 2-d : X⁻=SCN⁻ |
| | | 2-e : X⁻=CF₃COO⁻ |
| | | 2-f : X⁻=CH₃SO₃⁻ |
| 3 | 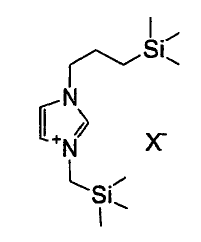 | 3-a : X⁻=l⁻ |
| | | 3-b : X⁻=N-(SO₂CF₃)₂ |
| | | 3-c : X⁻=BF₄⁻ |
| | | 3-d : X⁻=SCN⁻ |
| | | 3-e : X⁻=CF₃COO⁻ |
| | | 3-f: X=CH₃SO₃- |
| 4 | 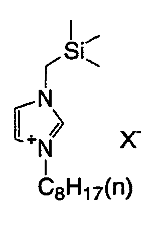 | 4-a:x=l⁻ |
| | | 4-b : X=N⁻(SO₂CF₃)₂ |
| | | 4-c : X=BF₄⁻ |
| | | 4-d : X=SCN⁻ |
| | | 4-e : X=CF₃COO⁻ |
| | | 4-f : X=CH₃SO₃⁻ |
| 5 | 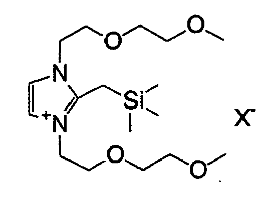 | 5-a : X=l⁻ |
| | | 5-b : X=N⁻(SO₂CF₃)₂ |
| | | 5-c : X⁻=BF4⁻ |
| | | 5-d : X⁻=SCN⁻ |
| | | 5-e : X⁻=CF₃COO⁻ |
| | | 5-f : X-=CH₃SO₃⁻ |
| 6 | 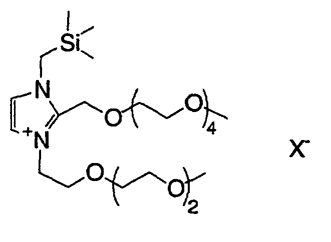 | 6-a : X⁻=I⁻ |
| | | 6-b : X⁻=N⁻(SO₂CF₃)₂ |
| | | 6-c: X⁻=BF₄⁻ |
| | | 6-d : X⁻=SCN⁻ |
| | | 6-e : X⁻=CF₃COO⁻ |
| | | 6-f : X⁻=CH₃SO₃⁻ |
| 7 | 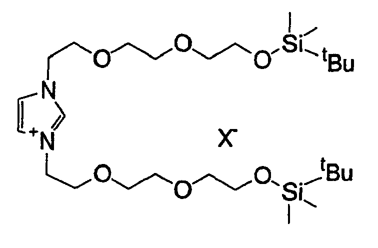 | 7-a : X⁻=I⁻ |
| | | 7-b : X⁻=N⁻(SO₂CF₃)₂ |
| | | 7-c: X⁻=BF₄⁻ |
| | | 7-d : X=SCN⁻ |
| | | 7-e : X⁻=CF₃COO⁻ |
| | | 7-f : X⁻=CH₃SO₃⁻ |
| 8 | 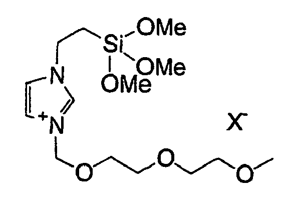 | 8-a : X⁻=I⁻ |
| | | 8-b : X⁻=N⁻(SO₂CF₃)₂ |
| | | 8-c : X⁻=BF4⁻ |
| | | 8-d : X⁻=SCN⁻ |
| | | 8-e : X⁻=CF₃COO⁻ |
| | | 8-f : X⁻=CH₃SO₃⁻ |
| 9 | 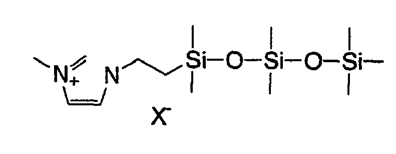 | 9-a : X⁻=I⁻ |
| | | 9-b : X⁻=N⁻(SO₂CF₃)₂ |
| | | 9-c : X=BF₄⁻ |
| | | 9-d : X⁻=SCN⁻ |
| | | 9-e : X⁻=CF₃COO⁻ |
| | | 9-f : X⁻=CH₃SO₃⁻ |
| 10 | 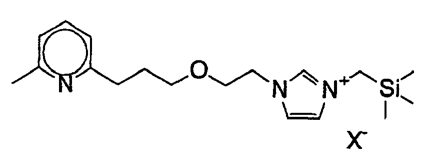 | 10-a : X⁻=I⁻ |
| | | 10-b : X⁻=N⁻(SO₂CF₃)₂ |
| | | 10-c: X⁻=BF₄⁻ |
| | | 10-d : X⁻=SCN⁻ |
| | | 10-e : X⁻=CF₃COO⁻ |
| | | 1 0-f : X⁻=CH₃SO₃⁻ |
| 11 | | 11-a:X=l⁻ |
| | 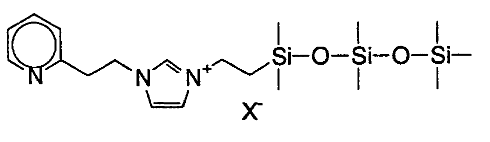 | 11-b: X=N⁻(SO₂CF₃)₂ |
| | | 11-c : X=BF4 |
| | | 11-d : X=SCN⁻ |
| | | 11-e :X⁻=CF₃COO⁻ |
| | | 11-f: X⁻=CH₃SO₃⁻ |
| 12 | 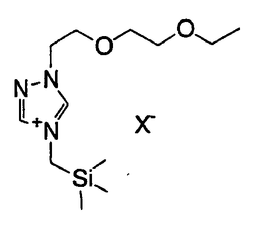 | 12-a:X⁻=l⁻ |
| | | 12-b:X⁻=N⁻(SO₂CF₃)₂ |
| | | 12-c: X=BF₄⁻ |
| | | 12-d : X=SCN⁻ |
| | | 12-e: X⁻=CF₃COO⁻ |
| | | 12-f : X⁻=CH₃SO₃⁻ |
| 13 | 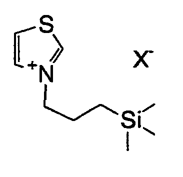 | 13-a : X=l⁻ |
| | | 13-b:X⁻=N⁻(SO₂CF₃)₂ |
| | | 13-c: X⁻=BF₄⁻ |
| | | 13-d:X⁻=SCN⁻ |
| | | 13-e: X⁻=CF₃COO⁻ |
| | | 13-f: X⁻=CH₃SO₃⁻ |
| 14 | 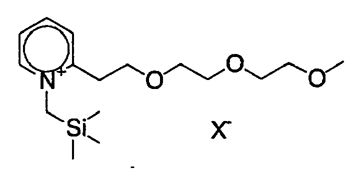 | 14-a:X⁻=l⁻ |
| | | 14-b : X=N⁻ (SO₂CF₃)₂ |
| | | 14-c : X=BF₄⁻ |
| | | 14-d : X=SCN⁻ |
| | | 14-e : X⁻=CF₃COO⁻ |
| | | 14-f : X⁻=CH₃SO₃⁻ |
| 15 | 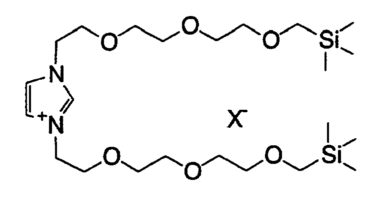 | 15-a : X=I⁻ |
| | | 15-b : X⁻=N⁻(SO₂CF₃)₂ |
| | | 15-c : X⁻=BF4⁻ |
| | | 15-d : X=SCN⁻ |
| | | 15-e : X⁻=CF₃COO⁻ |
| | | 15-f : X=CH₃SO₃ |
| 16 | 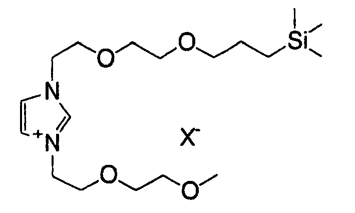 | 16-a : X⁻=I⁻ |
| | | 16-b : X⁻=N⁻(SO₂CF₃)₂ |
| | | 16-c : X⁻=BF₄⁻ |
| | | 16-d : X⁻=SCN⁻ |
| | | 16-e : X⁻=CF₃COO⁻ |
| | | 16-f : X⁻=CH₃SO₃⁻ |
| 17 | 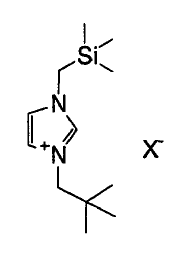 | 17-a : X⁻=I⁻ |
| | | 17-b : X⁻=N⁻(SO₂CF₃)₂ |
| | | 17-c : X=BF₄⁻ |
| | | 17-d : X⁻=SCN⁻ |
| | | 17-e : X⁻=CF₃COO⁻ |
| | | 17-f : X⁻=CH₃SO₃⁻ |
| 18 | | 18-a: X⁻=l⁻ |
| | | 18-b : X⁻=N⁻(SO₂CF₃)₂ |
| | 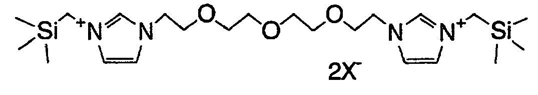 | 18-c : X⁻=BF₄⁻ |
| | | 18-d : X⁻=SCN⁻ |
| | | 18-e: X⁻=CF₃COO⁻ |
| | | 18-f : X=CH₃SO3⁻ |
| 19 | 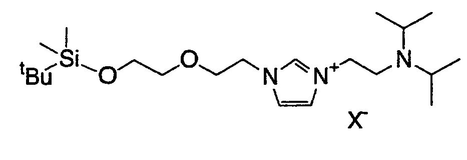 | 19-a : X⁻=I⁻ |
| | | 19-b: X⁻=N⁻(SO₂CF₃)₂ |
| | | 19-c : X⁻=BF₄⁻ |
| | | 19-d : X⁻=SCN⁻ |
| | | 19-e : X⁻=CF₃COO⁻ |
| 20 | 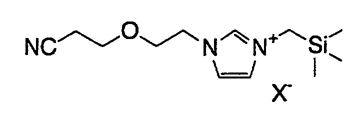 | 20-a: X⁻=I⁻ |
| | | 20-b : X⁻=N⁻(SO₂CF₃)₂ |
| | | 20-c : X⁻=BF₄⁻ |
| | | 20-d : X=SCN⁻ |
| | | 20-e : X⁻=CF₃COO⁻ |
| 21 | 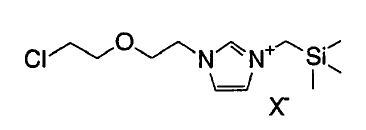 | 21-a : X'=1' |
| | | 21-b : X⁻=N⁻(SO₂CF₃)₂ |
| | | 21-c: X'=BF₄⁻ |
| | | 21-d : X⁻=SCN⁻ |
| | | 21-e : X⁻=CF₃COO⁻ |
| 22 | 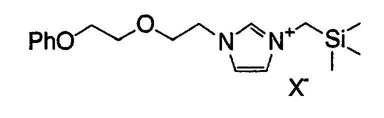 | 22-a : X⁻=l⁻ |
| | | 22-b : X=N⁻(SO₂CF₃)₂ |
| | | 22-c : X⁻=BF₄⁻ |
| | | 22-d : X⁻=SCN⁻ |
| | | 22-e : X⁻=CF₃COO⁻ |

### (B) Iodine salt and/or Iodine

The electrolyte composition of the present invention preferably comprises an iodine salt and/or iodine. Particularly, when the compound represented by the general formula (1) is not an iodine salt, it is preferable that the known iodine salt such as pyridinium salts, imidazolium salts and triazolium salts disclosed in WO 95/18456, Japanese Patent Laid-Open No. 8-259543, Denki Kagaku, 65, 11, 923 (1997), etc. is added to the electrolyte composition. In the case where the compound represented by the general formula (1) is an iodine salt, the electrolyte composition may further comprise another salt with no iodide ion.

When the compound represented by the general formula (1) is used together with the other salt, a content of the compound is preferably 10 weight % or more, more preferably 20 to 95 weight % based on the entire electrolyte composition. Additionally, the iodine salt content is preferably 10 weight % or more, more preferably 50 to 95 weight % based on the entire electrolyte composition.

In the case where the electrolyte composition comprises iodine, the iodine content is preferably 0.1 to 20 weight %, more preferably 0.5 to 5 weight % based on the entire electrolyte composition.

The preferred iodine salt used together with the compound represented by the general formula (1) is such that represented by any of the following general formulae (Y-a), (Y-b) and (Y-c), etc.

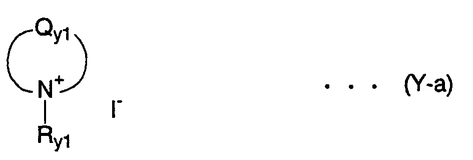

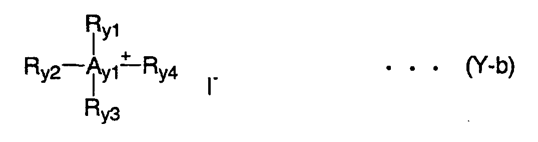

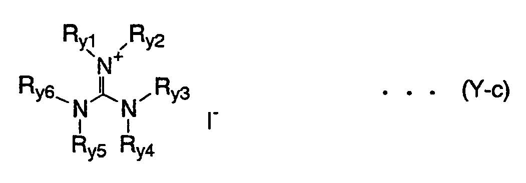

In the general formula (Y-a), Q_{y1} represents an atomic group forming an aromatic cation having a 5- or 6-membered ring structure with a nitrogen atom. Q_{y1} is preferably composed of atoms selected from the group consisting of carbon, hydrogen, nitrogen, oxygen and sulfur atoms.

As for the 5-membered ring formed by Q_{y1}, preferred are such rings as an oxazole ring, a thiazole ring, an imidazole ring, a pyrazole ring, an iso-oxazole ring, a thiadiazole ring, an oxadiazole ring and a triazole ring. The 5-membered ring is more preferably an oxazole ring, a thiazole ring or an imidazole ring, particularly preferably an oxazole ring or an imidazole ring. As for the 6-membered ring formed by Q_{y1}, preferred are such rings as a pyridine ring, a pyrimidine ring, a pyridazine ring, a pyrazine ring and a triazine ring. The 6-membered ring is more preferably a pyridine ring.

In the general formula (Y-b), A_{y1} represents a nitrogen atom or a phosphorus atom.

R_{Y1} to R_{y6} in the general formulae (Y-a), (Y-b) and (Y-c) independently represent: a substituted or unsubstituted alkyl group preferably having 1 to 24 carbon atom, which may be straight or branched, or cyclic, such as a methyl group, an ethyl group, a propyl group, an isopropyl group, a pentyl group, a hexyl group, an octyl group, a 2-ethylhexyl group, a *t*-octyl group, a decyl group, a dodecyl group, a tetradecyl group, a 2-hexyldecyl group, an octadecyl group, a cyclohexyl group, a cyclopentyl group, etc.; or a substituted or unsubstituted alkenyl group preferably having 2 to 24 carbon atoms, which may be straight or branched, such as a vinyl group, an allyl group, etc. R_{y1} to R_{y6} is more preferably an alkyl group having 2 to 18 carbon atoms or an alkenyl group having 2 to 18 carbon atoms, particularly preferably an alkyl group having 2 to 6 carbon atoms. Herein, three or more of R_{y1} to R_{y4} in the general formula (Y-b) are not an alkenyl group at the same time.

Two or more of R_{y1} to R_{y4} in the general formula (Y-b) may be bonded together to form a non-aromatic ring containing A_{y1}. Two or more of R_{y1} to R_{y6} in the general formula (Y-c) may be bonded together to form a ring.

Q_{y1} and R_{y1} to R_{y6} in the general formulae (Y-a), (Y-b) and (Y-c) may have a substituent. Preferable examples of the substituent include: a halogen atom such as F, Cl, Br and I; a cyano group; an alkoxy group such as a methoxy group and an ethoxy group; an aryloxy group such as a phenoxy group; an alkylthio group such as a methylthio group and an ethylthio group; an alkoxycarbonyl group such as an ethoxycarbonyl group; a carbonate group such as an ethoxycarbonyloxy group; an acyl group such as an acetyl group, a propionyl group and a benzoyl group; a sulfonyl group such as a methane sulfonyl group and a benzene sulfonyl group; an acyloxy group such as an acetoxy group and a benzoyloxy group; a sulfonyloxy group such as a methane sulfonyloxy group and a toluene sulfonyloxy group; a phosphonyl group such as a diethylphosphonyl group; an amido group such as an acetylamino group and a benzoylamino group; a carbamoyl group such as an *N,N*-dimethylcarbamoyl group; an alkyl group such as a methyl group, an ethyl group, a propyl group, an isopropyl group, a cyclopropyl group, a butyl group, a 2-carboxyethyl group and a benzyl group; an aryl group such as a phenyl group and a toluyl group; a heterocyclic group such as a pyridyl group, an imidazolyl group and a furanyl group; an alkenyl group such as a vinyl group and a 1-propenyl group; etc.

The iodine salt represented by the general formula (Y-a), (Y-b) or (Y-c) may form an oligomer (polymer) through Q_{y1} or R_{y1} to R_{y6}. The iodine salt represented by the general formula (Y-a), (Y-b) or (Y-c) may be used singly or as a mixture containing a plurality thereof.

The iodine salt represented by the general formula (Y-a), (Y-b) or (Y-c) may be used with such a salt that I⁻ thereof is changed into the other anion. The other anion is preferably halide ions such as Cl⁻ and Br⁻, NCS⁻, BF₄⁻, PF₆⁻, ClO₄⁻, N⁻(SO₂CF₃)₂, N⁻(SO₂CF₂CF₃)₂, CF₃SO₃⁻, CF₃COO⁻, BPh₄⁻, C⁻(SO₂CF₃)₃, etc., more preferably N⁻(SO₂CF₃)₃ or BF₄⁻. Also, the iodine salt represented by the general formula (Y-a), (Y-b) or (Y-c) may be used with another iodine salt such as LiI, etc.

### (C) Solvent

The electrolyte composition of the present invention may comprise a solvent. A solvent content of the electrolyte composition is preferably 0 to 50 weight %, more preferably 0 to 30 weight %, particularly preferably 0 to 10 weight % based on the entire electrolyte composition.

The solvent used in the present invention is preferably such that has a low viscosity and a high ionic mobility, and/or that has a high permittivity and can increase the actual carrier concentration of the electrolyte composition, to exhibit an excellent ionic conductibility. Examples of the solvent include: carbonates such as ethylene carbonate and propylene carbonate; heterocyclic compounds such as 3-methyl-2-oxazolidinone; ethers such as dioxan and diethyl ether; chain ethers such as ethyleneglycol dialkylethers, propyleneglycol dialkylethers, polyethyleneglycol dialkylethers and polypropyleneglycol dialkylethers; alcohols such as methanol, ethanol, ethyleneglycol monoalkylethers, propyleneglycol monoalkylethers, polyethyleneglycol monoalkylethers and polypropyleneglycol monoalkylethers; glycols such as ethylene glycol, propylene glycol, polyethylene glycol, polypropylene glycol and glycerin; nitriles such as acetonitrile, glutarodinitrile, methoxyacetonitrile, propionitrile, benzonitrile and biscyanoethyl ether; esters such as carboxylates, phosphates and phosphonates; aprotic polar solvents such as dimethylsulfoxide (DMSO) and sulfolane; water; etc. These solvents may be mixed to use.

### (D) Others

The electrolyte composition of the present invention may be gelled (solidified) at practical use. The gelation may be achieved by: adding a polymer; adding an oil-gelling agent; polymerization of monomers comprising multifunctional monomers; a cross-linking reaction of a polymer; etc.

In the case where the electrolyte composition is gelled by adding a polymer, compounds described in "Polymer Electrolyte Reviews-1 and 2", edited by J. R. MacCallum and C. A. Vincent, ELSEVIER APPLIED SCIENCE may be used as the polymer. Polyacrylonitrile or poly(vinylidene fluoride) is preferably used.

In the case where the electrolyte composition is gelled by adding an oil-gelling agent, compounds described in J. Chem. Soc. Japan, Ind. Chem. Soc., 46, 779 (1943), J. Am. Chem. Soc., 111, 5542 (1989), J. Chem. Soc., Chem. Commun., 390 (1993), Angew. Chem. Int. Ed. Engl., 35, 1949 (1996), Chem. Lett., 885 (1996), J. Chem. Soc., Chem. Commun., 545 (1997), etc. may be used as the oil-gelling agent. Of the compounds, preferred are those having an amide structure.

In the case where a gel electrolyte composition is formed by polymerization of multifunctional monomers, the gelation is preferably achieved by the method comprising the steps of: preparing a solution composed of the multifunctional monomers, a polymerization initiator, the electrolyte and a solvent; forming a sol electrolyte layer on an electrode having a dye by a casting method, a coating method, a soaking method, an impregnation method, etc.; and radical-polymerizing the multifunctional monomers. It is preferable that the multifunctional monomer has two or more ethylenycally unsaturated groups. Preferable examples thereof include divinyl benzene, ethyleneglycol diacrylate, ethyleneglycol dimethacrylate, diethyleneglycol diacrylate, diethyleneglycol dimethacrylate, triethyleneglycol diacrylate, triethyleneglycol dimethacrylate, pentaerythritol triacrylate and trimethylolpropane triacrylate.

The gel electrolyte composition may be formed by polymerizing a mixture containing the multifunctional monomers and unifunctional monomers. Preferable examples of the unifunctional monomers include: acrylic acid and α-alkylacrylic acids (e.g. acrylic acid, methacrylic acid, itaconic acid, etc.), and esters or amides derived therefrom (e.g. methyl acrylate, ethyl acrylate, *n*-propyl acrylate, *i*-propyl acrylate, *n*-butyl acrylate, *i*-butyl acrylate, *t*-butyl acrylate, *n-*pentyl acrylate, 3-pentyl acrylate, *t*-pentyl acrylate, *n*-hexyl acrylate, 2,2-dimethylbutyl acrylate, *n*-octyl acrylate, 2-ethylhexyl acrylate, 4-methyl-2-propylpentyl acrylate, cetyl acrylate, *n*-octadecyl acrylate, cyclohexyl acrylate, cyclopentyl acrylate, benzyl acrylate, hydroxyethyl acrylate, 2-hydroxypropyl acrylate, 2-methoxyethyl acrylate, 2-ethoxyethyl acrylate, 2-methoxyethoxyethyl acrylate, phenoxyethyl acrylate, 3-methoxybutyl acrylate, ethylcarbitol acrylate, 2-methyl-2-nitropropyl acrylate, 2,2,2-trifluoroethyl acrylate, octafluoropentyl acrylate, heptadecafluorodecyl acrylate, methyl methacrylate, *n*-butyl methacrylate, *i*-butyl methacrylate, *t*-butyl methacrylate, *t-*pentyl methacrylate, *n*-octadecyl methacrylate, benzyl methacrylate, hydroxyethyl methacrylate, 2-hydroxypropyl methacrylate, 2-methoxyethyl methacrylate, 2-ethoxyethyl methacrylate, 2-methoxyethoxyethyl methacrylate, dimethylaminoethyl methacrylate, 2,2,2-trifluoroethyl methacrylate, tetrafluoropropyl methacrylate, hexafluoropropyl methacrylate, heptadecafluorodecyl methacrylate, ethyleneglycol ethyl carbonate methacrylate, 2-isobornyl methacrylate, 2-norbornylmethyl methacrylate, 5-norbornen-2-ylmethyl methacrylate, 3-methyl-2-norbornylmethyl methacrylate, acrylamide, *N-i*-propyl acrylamide, *N-n*-butyl acrylamide, *N-t*-butyl acrylamide, *N*,*N*-dimethyl acrylamide, *N*-methylol acrylamide, diacetone acrylamide, 2-acrylamido-2-methylpropane sulfonic acid, acrylamidopropyltrimethyl ammonium chloride, methacrylamide, *N*-methylmethacrylamide, *N-*methylolmethacrylamide, etc.); vinyl esters (e.g. vinyl acetate, etc.); maleic acid and fumaric acid, and esters derived therefrom (e.g. dimethyl maleate, dibutyl maleate, diethyl fumarate, etc.); acrylonitrile and methacrylonitrile; dienes (e.g. butadiene, cyclopentadiene, isoprene, etc.); aromatic vinyl compounds (e.g. styrene, *p*-chlorostyrene, *t*-butylstyrene, *α*-methylstyrene, sodium *p-*styrenesulfonate, etc.); *N*-vinylformamide, *N*-vinyl-*N*-methylformamide, *N-*vinylacetamide, and *N*-vinyl-*N*-methylacetamide; vinyl sulfonic acid; sodium vinylsulfonate, sodium allylsulfonate and sodium methacrylsulfonate; vinylidene fluoride and vinylidene chloride; vinyl alkyl ethers (e.g. methyl vinyl ether, etc.); ethylene, propylene, 1-butene and isobutene; and *N*-phenyl maleimide.

The weight ratio of the multifunctional monomers to all the monomers is preferably 0.5 to 70 weight %, more preferably 1.0 to 50 weight %.

The above-described monomers can be polymerized by general radical polymerization method described in Takayuki Otsu and Masaetsu Kinoshita, "Kobunshi Gosei no Jikkenho" (Kagaku Dojin), Takayuki Otsu, "Koza Jugo Hannoron 1 Rajikaru Jugo (I)" (Kagaku Dojin), etc. The radical polymerization may be achieved by heating, light or electron ray, or electrochemical method. Among them, heat-polymerization is particularly preferable.

Preferable examples of the polymerization initiator used in the present invention include: azo initiators such as 2,2'-azobis(isobutyronitrile), 2,2'-azobis(2,4-dimethylvaleronitrile), dimethyl 2,2'-azobis(2-methylpropionate) and dimethyl 2,2'-azobis(isobutyate); peroxide initiators such as lauryl peroxide, benzoyl peroxide and *t*-butyl peroctoate; etc. The weight ratio of the initiator to all the monomers is preferably 0.01 to 20 weight %, more preferably 0.1 to 10 weight %.

The weight ratio of the monomers accounting for the gel electrolyte composition is preferably in the range of 0.5 to 70 weight %, more preferably 1.0 to 50 weight %.

In the case where the gelation of the electrolyte composition is accomplished by the cross-linking reaction of polymer, a polymer containing a group having cross-linking reactivity is preferably added to the composition in combination with a cross-linking agent. The group having cross-linking reactivity is preferably a nitrogen-containing heterocyclic group such as a pyridyl group, an imidazolyl group, a thiazolyl group, an oxazolyl group, a triazolyl group, a morpholyl group, a piperidyl group, a piperazyl group, etc. Preferable cross-linking agent is an electrophilic agent having a plurality of functional group that can be attacked by the nitrogen atom, for example, multifunctional alkyl halides, aralkyl halides, sulfonates, acid anhydrides, acyl chlorides and isocyanates.

To the electrolyte composition of the present invention may be added: a metal iodide such as LiI, NaI, KI, CsI and CaI₂; a metal bromide such as LiBr, NaBr, KBr, CsBr and CaBr₂; a quaternary ammonium bromide such as a tetralkylammonium bromide and pyridinium bromide; a metal complex such as a ferrocyanide-ferricyanide and a ferrocene-ferricinium ion; a sulfur compound such as sodium polysulfide and alkylthiol-alkyldisulfide; a viologen dye; hydroquinone-quinone; etc. A plurality of the compounds may be mixed to be in use.

Further, to the electrolyte composition of the present invention may be added a basic compound such as *t*-butylpyridine, 2-picoline, 2,6-lutidine, etc. described in J. Am. Ceram. Soc., 80 (12), 3157 to 3171 (1997). The concentration of the basic compound is preferably 0.05 to 2 M based on the electrolyte composition.

When the electrolyte composition is used for the charge transfer layer of the photoelectric conversion device, the water-content of the charge transfer layer is preferably 10,000 ppm or less, more preferably 2,000 ppm or less, and particularly preferably 100 ppm or less.

### [2] Photoelectric Conversion Device

The photoelectric conversion device according to the present invention has an electrically conductive layer, a photosensitive layer, a charge transfer layer and a counter electrode. The charge transfer layer comprises the electrolyte composition of the present invention mentioned above.

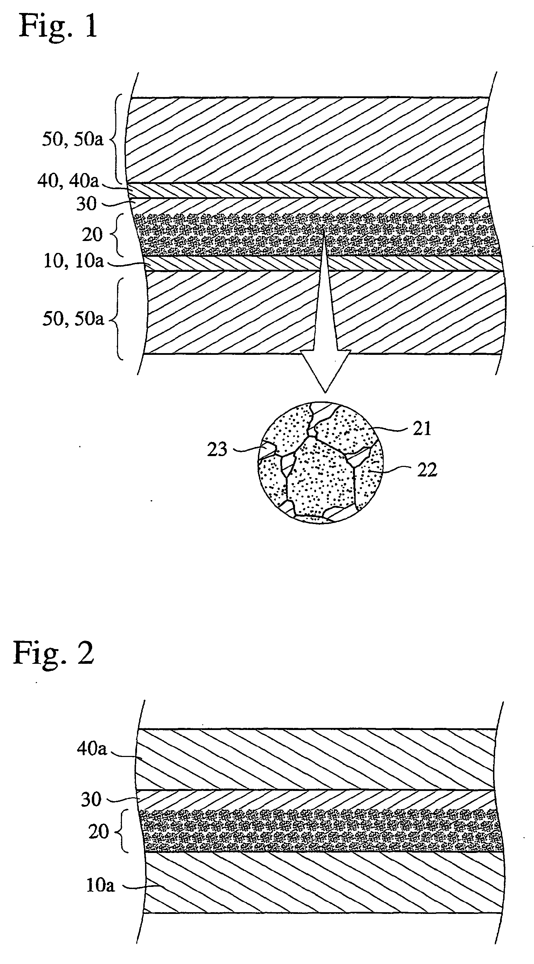

As shown in Fig. 1, the photoelectric conversion device preferably comprises an electrically conductive layer 10, a photosensitive layer 20 composed of semiconductor fine particles 21 sensitized by a dye 22 and an charge-transporting material 23 penetrated into voids among the particles, a charge transfer layer 30, and a counter electrically conductive layer 40 laminated in this order. The charge-transporting material 23 is preferably the same as the electrolyte composition used in the charge transfer layer 30. On the electrically conductive layer 10 and/or the counter electrically conductive layer 40 may be disposed a substrate 50 to improve the strength of the photoelectric conversion device. Hereinafter in the present invention, a layer composed of the electrically conductive layer 10 and the substrate 50 disposed thereon if necessary is referred to as "conductive support", and a layer composed of the counter electrically conductive layer 40 and the substrate 50 disposed thereon if necessary is referred to as "counter electrode". A photo-electrochemical cell of the present invention is constituted by connecting the device to an outer circuit. Incidentally, the electrically conductive layer 10, the counter electrically conductive layer 40 and the substrate 50 shown in Fig. 1 may be a transparent electrically conductive layer 10a, a transparent counter electrically conductive layer 40a and a transparent substrate 50a, respectively.

In the photoelectric conversion device shown in Fig. 1, a light injected to the photosensitive layer 20 excites the dye 22, etc., excited high energy electrons therein are transported to a conduction band of the semiconductor fine particles 21, and they are diffused to reach to the electrically conductive layer 10. At this time, the dye 22 is in oxidized form. In the photo-electrochemical cell, electrons in the electrically conductive layer 10 are returned to the oxidized dye through the counter electrically conductive layer 40 and the charge transfer layer 30 while working in the outer circuit, so that the dye 22 is regenerated. The photosensitive layer 20 acts as a negative electrode. In a boundary of each layer such as a boundary between the electrically conductive layer 10 and the photosensitive layer 20, a boundary between the photosensitive layer 20 and the charge transfer layer 30, a boundary between the charge transfer layer 30 and the counter electrically conductive layer 40, etc., components of each layer may be diffused and mixed. Each of the layers will be explained in detail below.

### (A) Conductive Support

The conductive support is: (1) a single layer of the electrically conductive layer; or (2) two layers of the electrically conductive layer and the substrate. The substrate is not necessary in the case where the electrically conductive layer has a high strength and can sufficiently seal the photoelectric conversion device.

In the case of (1), the electrically conductive layer is preferably made of a material having a sufficient strength and an electrical conductivity such as a metal, etc.

In the case of (2), as the conductive support may be used the substrate on which the electrically conductive layer containing an electrically conductive agent is disposed at the photosensitive layer side. Preferable examples of the electrically conductive agent include: metals such as platinum, gold, silver, copper, aluminum, rhodium and indium; carbon; and electrically conductive metal oxides such as indium-tin composite oxides and tin oxides doped with fluorine; etc. The thickness of the electrically conductive layer is preferably 0.02 to 10 µm.

The surface resistance of the conductive support is preferably as low as possible. The surface resistance is preferably 100 Ω/square or less, more preferably 40 Ω/square or less. The lowest limit thereof is generally approximately 0.1 Ω/square, not limited in particular.

When a light is irradiated through the conductive support, it is preferred that the conductive support is substantially transparent. Herein, the term "substantially transparent" means light-transmittance is 10 % or more. The light-transmittance of the conductive support is more preferably 50 % or more, particularly preferably 70 % or more.

The transparent conductive support is preferably constituted by forming the transparent electrically conductive layer of an electrically conductive metal oxide on the transparent substrate of such material as a glass and a plastic by coating or vapor deposition. Of such transparent conductive supports, particularly preferred is a transparent electrically conductive substrate made of a low-cost soda-lime float glass, on which the electrically conductive layer composed of a tin oxide doped with fluorine is deposited. To obtain a low-cost and flexible photoelectrical conductive device or solar cell, a transparent polymer film disposed the electrically conductive layer thereon is preferably used as the transparent conductive support. As the materials for the transparent polymer film, tetracetylcellulose (TAC), polyethylene terephthalate (PET), polyethylene naphthalate (PEN), syndiotactic polystyrene (SPS), polyphenylenesulfide (PPS), polycarbonate (PC), polyarylate (PAr), polysulfone (PSF), polyestersulfone (PES), polyetherimide (PEI), cyclic polyolefin, brominated phenoxy, etc. may be used. To secure a sufficient transparency, the coating amount of the electrically conductive metal oxide is preferably 0.01 to 100 g per 1 m² of the glass or plastic substrate.

It is preferable that a metal lead is used to reduce a resistance of the transparent conductive support. Material for the metal lead is preferably aluminum, copper, silver, gold, platinum, nickel, etc., particularly preferably aluminum or silver. It is preferable that the metal lead is disposed on the transparent substrate by a vapor deposition method, a sputtering method, etc., the transparent electrically conductive layer of a tin oxide doped with fluorine, an ITO film, etc. being formed thereon. It is also preferable that after forming the transparent electrically conductive layer on the transparent substrate, the metal lead is disposed on the electrically conductive layer. The reduction in quantity of incident light owing to the metal lead is suppressed to preferably 10 % or less, more preferably 1 to 5 %.

### (B) Photosensitive Layer

The photosensitive layer preferably comprises semiconductor fine particles sensitized by a dye. The semiconductor fine particles act as a so-called "photosensitive substance" to absorb a light and conduct charge separation, thereby generating electrons and positive holes. With respect to the dye-sensitized semiconductor fine particles, the light-absorption and the generation of electrons and positive holes are primarily caused in the dye, and the semiconductor fine particles receive and convey the electrons.

### (1) Semiconductor Fine Particles

Used as the semiconductor fine particles may be: simple semiconductors such as silicone and germanium; III-V series compound semiconductors; metal chalcogenides such as oxides, sulfides and selenides; compounds with a perovskite structure such as strontium titanate, calcium titanate, sodium titanate, barium titanate and potassium niobate; etc. The semiconductor fine particles are preferably metal chalcogenide fine particles.

Preferable examples of the metal chalcogenide include: oxide of titanium, tin, zinc, iron, tungsten, zirconium, hafnium, strontium, indium, cerium, yttrium, lanthanum, vanadium, niobium or tantalum; sulfide of cadmium, zinc, lead, silver, antimony or bismuth; selenide of cadmium or lead; and cadmium telluride; etc. Additionally, the other compound semiconductors such as phosphide of zinc, gallium, indium or cadmium, selenide of gallium-arsenic or copper-indium, copper-indium sulfide, etc. may be used in this invention.

Preferable specific examples of the semiconductor used in the present invention include Si, TiO₂, SnO₂, Fe₂O₃, WO₃, ZnO, Nb₂O₅, CdS, ZnS, PbS, Bi₂S₃, CdSe, CdTe, GaP, InP, GaAs, CuInS₂ and CuInSe₂. Of these semiconductors, more preferred are TiO₂, ZnO, SnO₂, Fe₂O₃, WO₃, Nb₂O₅, CdS, PdS, CdSe, InP, GaAs, CuInS₂ and CuInSe₂, particularly preferred are TiO₂ and Nb₂O₅, and the most preferred is TiO₂.

The semiconductor may have a single crystal or poly crystal structure. The single crystal semiconductor is preferred from a viewpoint of a conversion efficiency, while the poly crystal semiconductor is preferred from viewpoints of a production cost, security of raw materials, an energy-payback time, etc.

The particle size of the semiconductor fine particles is generally in the nm to µm level. The mean size of primary particles, which is obtained from a diameter of a circle equivalent to a projected area, is preferably 5 to 200 nm, more preferably 8 to 100 nm. Further, the mean size of the secondary semiconductor fine particles in dispersion is preferably 0.01 to 100 µm.

Two or more kinds of particles having a different particle size distribution may be mixed to use in the photosensitive layer. In this case, the average particle size of the smaller particles is preferably 5 nm or less. To improve a light-capturing rate of the photoelectric conversion device by scattering a ray of light, the semiconductor fine particles having a large particle size, e.g. approximately 300 nm in diameter, may be added to the mixture composing the semiconductor layer.

Preferred as a method for producing the semiconductor fine particles are: sol-gel methods described in Sumio Sakka, "Science of a sol-gel method", Agune Shofusha (1998), Technical information Association, "Thin film-coating technology by a sol-gel method" (1995), etc.; and gel-sol methods described in Tadao Sugimoto, "Synthesis of mono-dispersion particles and control of their size and form by a novel gel-sol method", and MATERIA, Vol. 35, No. 9, page 1012 to 1018 (1996). The method developed by Degussa Company, which comprises preparing oxides by subjecting chlorides to a high temperature hydrolysis in an oxyhydrogen salt, is also preferred.

In the case where titanium oxide is used as the semiconductor fine particles, any of the above-described sol-gel methods, gel-sol methods and high temperature hydrolysis method is preferably used, further, a sulfuric acid method and a chlorine method described in Manabu Seino, "Titanium oxide - properties and applied technique", Gihodo Shuppan, (1997) may be used. Of the sol-gel methods, also preferred are such that described in Christophe J. Barb'e, et al, Journal of American Ceramic Society, Vol. 80, No. 12, page 3157 to 3171 (1997) and Burnside, et al, Chemical Materials, Vol. 10, No. 9, page 2419 to 2425.

### (2) Semiconductor Fine Particle Layer

The semiconductor fine particles may be coated on the conductive support by a method where a dispersion solution or a colloid solution containing the particles is applied on the electrically conductive layer, the above-mentioned sol-gel method, etc. A wet type film production method is relatively advantageous for the mass production of the photoelectric conversion device, improvement of properties of semiconductor fine particle solution and adaptability of the conductive support, etc. As such a wet type film production method, a coating method and a printing method are typical examples.

As a method for preparing the dispersion solution containing the semiconductor fine particles, the sol-gel method mentioned above may be used. Further, the dispersion solution may be prepared by crushing the semiconductor in a mortar, dispersing the semiconductor while grinding in a mill, or precipitating the semiconductor fine particles in a solvent when the semiconductor is synthesized.

As a dispersion solvent, water or organic solvents such as methanol, ethanol, isopropyl alcohol, dichloromethane, acetone, acetonitrile, ethyl acetate, etc. may be used. A polymer, a surfactant, an acid, a chelating agent, etc. may be used as a dispersing agent, if necessary.

Preferred coating methods are: a roller method and a dip method as an application series; an air-knife method and a blade method as a metering series; etc. Further, preferable as a method where an application and metering can be performed at the same time are a wire-bar method disclosed in JP-B-58-4589, a slide-hopper method described in United States Patent Nos. 2,681,294, 2,761,419, 2,761,791, etc., an extrusion method, a curtain method, etc. Furthermore, as for a wide use, a spin method and a spray method are preferred. As a wet type printing method, three major printing methods of a relief printing, an offset printing and a gravure printing, an intaglio printing, a gum printing, a screen printing, etc. are preferred. A preferable film production method may be selected from these methods in accordance with viscosity of the solution and a wet thickness.

The viscosity of the dispersion materially depends on the kind and dispersion property of the semiconductor fine particles, the kind of a solvent and additives such as a surfactant and a binder. For a high viscosity dispersion (e.g. 0.01 to 500 Poise), an extrusion method, a cast method, a screen printing method, etc. are preferably used. On the other hand, for a low viscosity dispersion (e.g. 0.1 Poise or less), a slide-hopper method, a wire-bar method and a spin method are preferably used to form a uniform film. An extrusion method may be used for the low viscosity dispersion if it is coated to some extent. A wet type film production method may be properly selected in accordance with the viscosity of the coating solution, the coating amount, the support, a coating speed and so on.

The semiconductor fine particle layer is not limited to a single layer. The dispersions each comprising the semiconductor fine particles having a different particle size may be subjected to a multi-layer coating. Further, the dispersions each containing different kinds of semiconductor fine particles, binder, or additives may be subjected to a multi-layer coating. A multi-layer coating is also effective when a film thickness is insufficient by coating once. Suitable for the multi-layer coating are an extrusion method and a slide-hopper method. When a multi-layer coating is carried out, a plurality of layers may be coated at the same time, or alternatively one over the other from several times to ten-several times. In the latter case, a screen method is also preferably used.

Generally, when the thickness of the semiconductor fine particle layer, which is equal to the thickness of the photosensitive layer, becomes thicker, the amount of the dye incorporated therein per unit of the projected area increases, thereby making the light capturing rate higher. However, because a diffusion distance of the generated electrons increases in this case, a loss owing to recombination of electric charges also increases. Consequently, a preferable thickness of the semiconductor fine particle layer is 0.1 to 100 µm. When the semiconductor fine particle layer is used for the photo-electrochemical cell, the thickness thereof is preferably 1 to 30 µm, more preferably 2 to 25 µm. A coating amount of the semiconductor fine particles per 1 m² of the support is preferably 0.5 to 400 g, more preferably 5 to 100 g.

After coating the semiconductor fine particles on the conductive support, the particles are preferably subjected to a heat treatment to electronically contact them with each other, and to increase a coating strength and an adherence thereof with the support. A heating temperature is preferably 40 ° C or more but less than 700 °C, more preferably 100 to 600 °C. A heating time is approximately 10 minutes to 10 hours. It is not preferred that a support having a low melting point or softening point such as a polymer film is subjected to a high temperature treatment because such a support tends to be deteriorated thereby. The heat treatment is preferably carried out at a temperature as low as possible also from a viewpoint of cost. The practice at such a low temperature is realized by a combination use with the above-described small semiconductor fine particles having a size of 5 nm or less, a heat treatment in the presence of a mineral acid, etc.

After a heat treatment, a chemical metal-plating using an titanium tetrachloride aqueous solution, etc. or an electrochemical metal-plating using an titanium trichloride aqueous solution may be carried out to increase a surface area of the semiconductor fine particles, or to enhance a purity in the vicinity of the particles, thereby improving an efficiency of electron injection into the particles from the dye.

It is preferable that the semiconductor fine particles have a large surface area to adsorb lots of dyes. Therefore, the surface area in the state that the semiconductor fine particle layer have been coated on the support is preferably 10 times or more, more preferably 100 times or more of the projected area. The highest limit, even though it is not limited in particular, is generally a level of 1000 times.

### (3) Dye

The dye used for the photosensitive layer in the present invention is preferably a metal complex dye, a phthalocyanine dye and/or a methine dye, more preferably a metal complex dye and/or a polymethine dye. Two or more kinds of dyes may be used as a mixture to obtain a large photoelectric conversion wavelength region and a high photoelectric conversion efficiency. In the case of using a plurality of the dyes as a mixture, the kinds and mixing ratio of the dyes may be selected in accordance with the wavelength region and the strength distribution of the light source.

The dye preferably has an appropriate interlocking group for interacting with the surface of the semiconductor fine particles. Preferred interlocking groups include -COOH, -OH, -SO₃H, a cyano group, -P(O)(OH)₂, -OP(O)(OH)₂, and π-conductive chelating groups such as oxime, dioxime, hydroxyquinoline, salicylate and α-ketoenolate groups. Among them, particularly preferred are-COOH, -P(O)(OH)₂ and -OP(O)(OH)₂. The interlocking group may form a salt with an alkali metal, etc. or an intramolecular salt. If the methine chain of the polymethine dye has an acidic group as in the case where the methine chain forms a squarylium ring or a croconium ring, it may act as the interlocking group.

The preferred dyes used for the photosensitive layer will be specifically described below.

### (a) Metal Complex Dye

The metal atom of the metal complex dye used in the present invention is preferably ruthenium atom. The ruthenium complex dyes described in United States Patent Nos. 4,927,721, 4,684,537, 5,084,365, 5,350,644, 5,463,057, 5,525,440, Japanese Patent Laid-Open No. 7-249790, JP-B-10-504512, WO 98/50393, etc. may be used in the present invention.

The ruthenium complex dye is preferably represented by the following formula (I):

(A₁)ₚRu(B-a)(B-b)(B-c) (I)

wherein A₁ represents a ligand selected from the group consisting of Cl, SCN, H₂O, Br, I, CN, NCO and SeCN; *p* is an integer of 0 to 2, preferably 2; and B-a, B-b, and B-c independently represent an organic ligand represented by any of the following formulae B-1 to B-8. 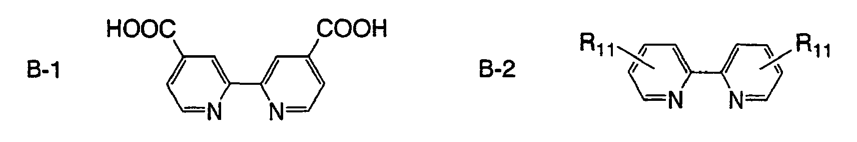 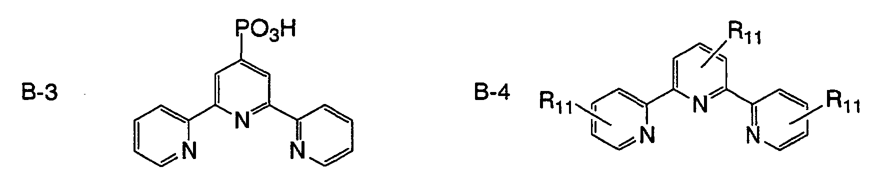 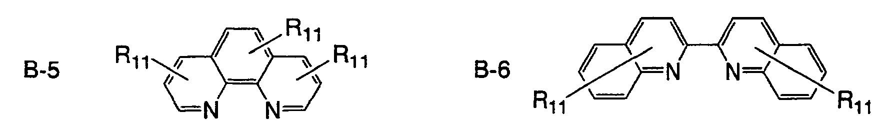 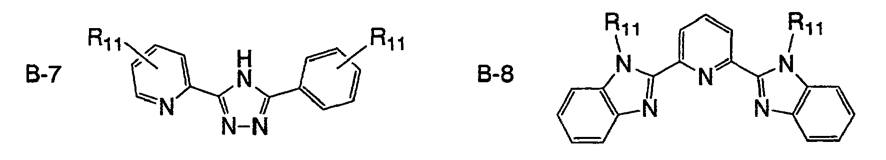 In the formulae B-1 to B-8, R₁₁ represents a substituent. Specific examples thereof include: a halogen atom; a substituted or unsubstituted alkyl group having 1 to 12 carbon atom; a substituted or unsubstituted aralkyl group having 7 to 12 carbon atoms; a substituted or unsubstituted aryl group having 6 to 12 carbon atoms; an acidic group that may form a salt such as a carboxyl group and a phosphono group; etc. The alkyl group and the alkyl moiety of the aralkyl group may be straight or branched, and the aryl group and the aryl moiety of the aralkyl group may have a monocyclic structure or a polycyclic structure such as a condensed ring and a ring assemblage. B-a, B-b and B-c may be the same or different ligands.

The metal complex dyes preferably usable in the present invention will be illustrated below without intention of restricting the scope of the present invention defined by the claims attached hereto.

(A₁)pRu(B-a)(B-b)(B-c) (I)

| | A₁ | p | B-a | B-b | B-c | R₁₁ |
|---|---|---|---|---|---|---|
| R-1 | SCN | 2 | B-1 | B-1 | - | - |
| R-2 | CN | 2 | B-1 | B-1 | - | - |
| R-3 | Cl | 2 | B-1 | B-1 | - | - |
| R-4 | Br | 2 | B-1 | B-1 | - | - |
| R-5 | I | 2 | B-1 | B-1 | - | - |
| R-6 | SCN | 2 | B-1 | B-2 | - | H |
| R-7 | SCN | 1 | B-1 | B-3 | - | - |
| R-8 | Cl | 1 | B-1 | B-4 | - | H |
| R-9 | I | 2 | B-1 | B-5 | - | H |
| R-10 | SCN | 2 | B-1 | B-6 | - | H |
| R-11 | CN | 2 | B-1 | B-7 | - | H |
| R-12 | Cl | 1 | B-1 | B-8 | - | H |
| R-13 | - | 0 | B-1 | B-1 | B-1 | - |

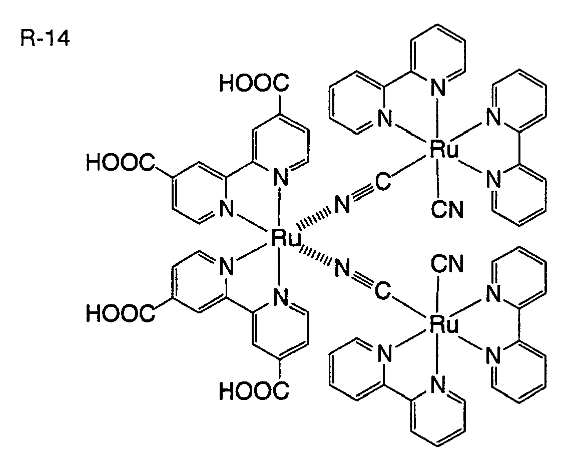

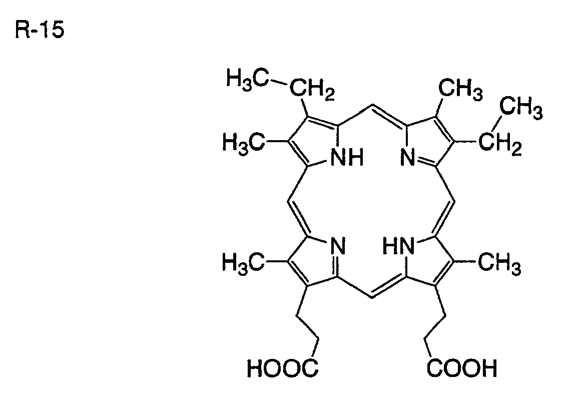

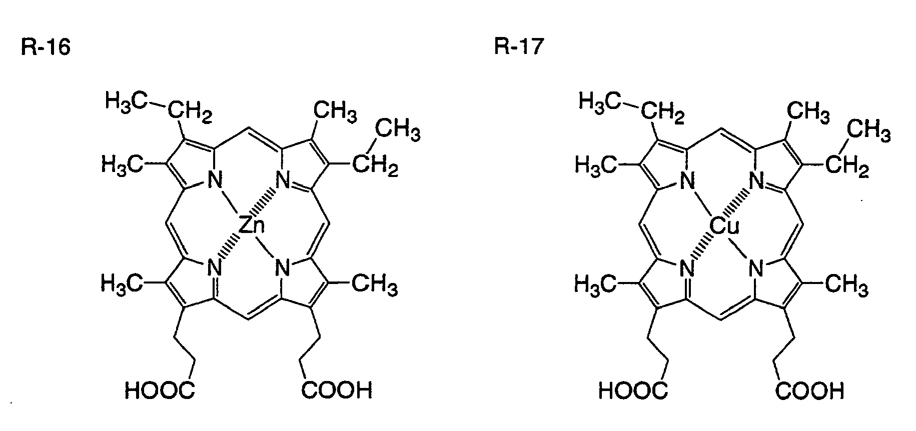

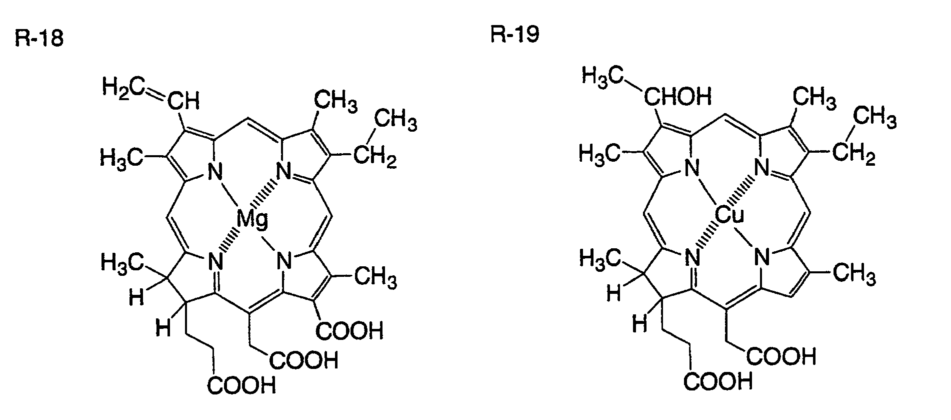

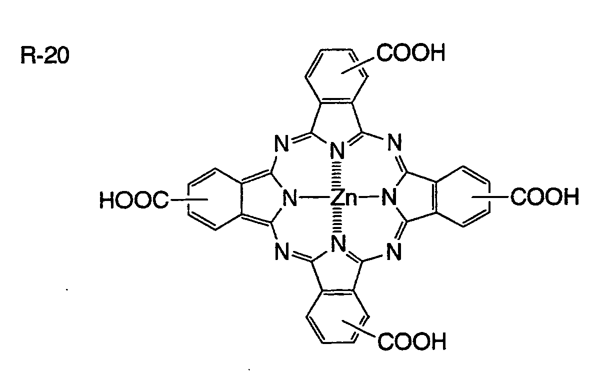

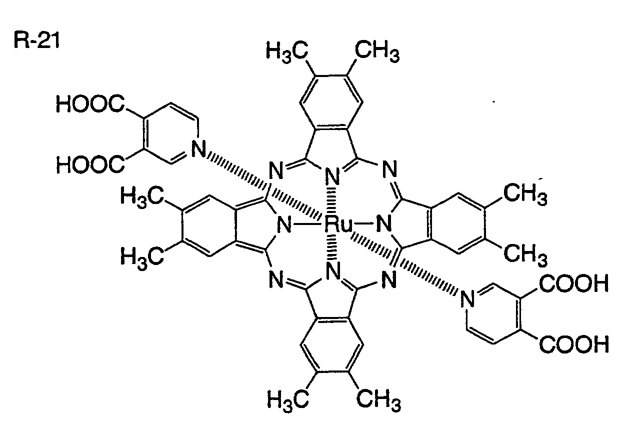

### (b) Methine Dye

The methine dyes used in the present invention are preferably represented by any of the following general formulae (II), (III), (IV) and (V).

### 1. General Formula (II)

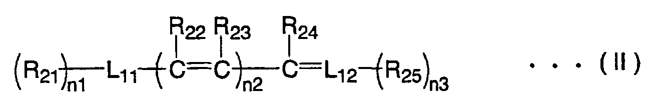

In the general formula (II), R₂₁ and R₂₅ independently represent a hydrogen atom, an alkyl group, an aryl group or a heterocyclic group; R₂₂ to R₂₄ independently represent a hydrogen atom or a substituent; R₂₁ to R₂₅ may be bonded together to form a ring; L₁₁ and L₁₂ independently represent a nitrogen atom, an oxygen atom, a sulfur atom, a selenium atom or a tellurium atom; n1 and n3 independently represent an integer of 0 to 2; and n2 represents an integer of 1 to 6. This dye may have a counter ion in agreement with the charge quantity of the whole molecule.

The above-mentioned alkyl group, aryl group and heterocyclic group may have a substituent. The alkyl group may be a straight or branched, and the aryl group and the heterocyclic group may have a monocyclic structure or a polycyclic structure such as a condensed ring and a ring assemblage. Further, the ring formed by R₂₁ to R₂₅ may have a substituent, and may be a monocyclic ring or a condensed ring.

### 2. General Formula (III)

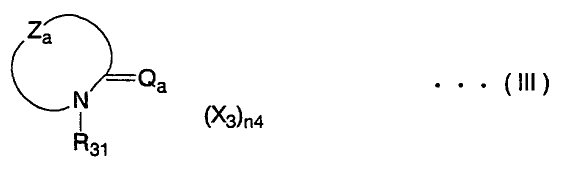

In the general formula (III), Zₐ represents a non-metal atomic group forming a nitrogen-containing heterocycle, and R₃₁ represents an alkyl group or an aryl group. Qₐ represents a methine group or a polymethine group necessary to act as a polymethine dye. The dye may form an oligomer or a polymer through Qₐ. X₃ represents a counter ion, and n4 indicating a number thereof represents an integer of 0 to 10.

The nitrogen-containing heterocycle formed by Zₐ may have a substituent, and may be a monocyclic ring or a condensed ring. The alkyl or aryl group represented by R₃₁ may have a substituent, the alkyl group may be a straight or branched, and the aryl group may have a monocyclic structure or a polycyclic structure such as a condensed ring and a ring assemblage.

Of the dyes represented by the general formula (III), more preferred are those represented by any of the following general formulae (III-a) to (III-d): 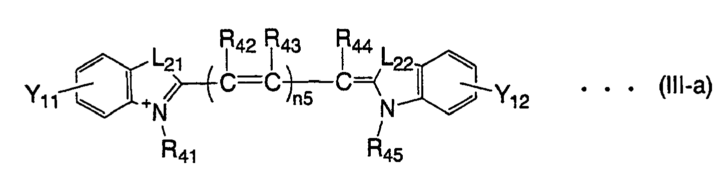 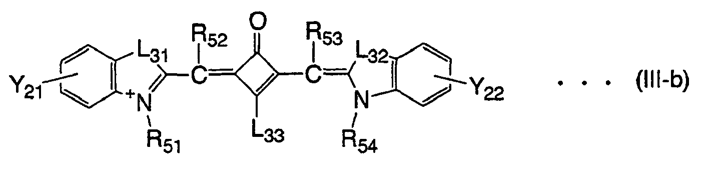 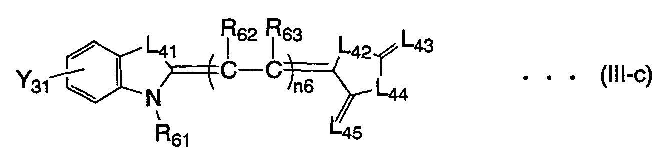 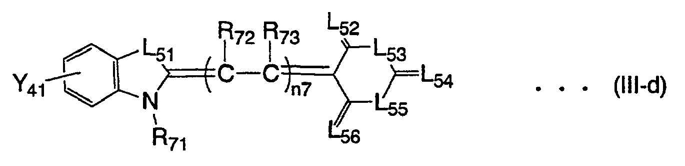 wherein R₄₁ to R₄₅, R₅₁ to R₅₄, R₆₁ to R₆₃ and R₇₁ to R₇₃ independently represent a hydrogen atom, an alkyl group, an aryl group or a heterocyclic group; L₂₁, L₂₂, L₃₁, L₃₂, L₄₁ to L₄₅ and L₅₁ to L₅₆ independently represent an oxygen atom, a sulfur atom, a selenium atom, a tellurium atom, -CRR'- or -NR- (in which R and R' independently represent a hydrogen atom, an alkyl group, an aryl group or a heterocyclic group, and may be the same or different); L₃₃ represents O⁻, S⁻, Se⁻, Te⁻ or N⁻R (in which R represents a hydrogen atom, an alkyl group, an aryl group or a heterocyclic group); Y₁₁, Y₁₂, Y₂₁, Y₂₂, Y₃₁ and Y₄₁ independently represent a substituent; and n5, n6, and n7 independently represent an integer of 1 to 6.

The dyes represented by any one of the general formulae (III-a) to (III-d) may have a counter ion in agreement with the charge of the molecule. The alkyl group, the aryl group and the heterocyclic group mentioned above may have a substituent, the alkyl group may be straight or branched, and the aryl group and the heterocyclic group may have a monocyclic structure or a polycyclic structure such as a condensed ring and a ring assemblage.

Specific examples of the polymethine dyes represented by the general formula (III) are described in detail in M. Okawara, T. Kitao, T. Hirashima and M. Matsuoka, Organic Colorants, Elsevier, etc.

### 3. General Formula (IV)

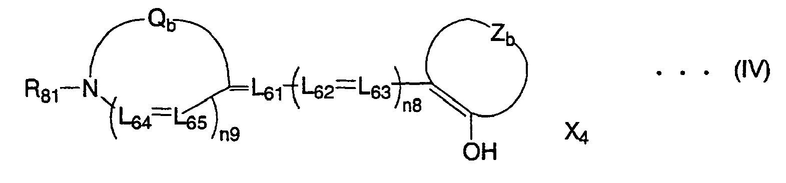

In the general formula (IV), Q_{b} represents an atomic group forming a 5-or 6-membered nitrogen-containing heterocycle; Z_{b} represents an atomic group forming a 3- to 9-membered ring; and L₆₁ to L₆₅ independently represent a substituted or unsubstituted methine group. n8 is an integer of 0 to 4, preferably an integer of 0 to 3, and n9 is 0 or 1. R₈₁ represents a substituent, and X₄ represents a counter ion contained if necessary to neutralize charge of the dye.

The nitrogen-containing heterocycle formed by Q_{b} may be a condensed ring, and may have a substituent. Preferable examples of the heterocycle include a benzothiazole ring, a benzoxazole ring, a benzoselenazole ring, a benzotellurazole ring, a 2-quinoline ring, a 4-quinoline ring, a benzoimidazole ring, a thiazoline ring, an indolenine ring, an oxadiazole ring, a thiazole ring and an imidazole ring. Of these, a benzothiazole ring, a benzoxazole ring, a benzoimidazole ring, a benzoselenazole ring, a 2-quinoline ring, a 4-quinoline ring and an indolenine ring are more preferred, a benzothiazole ring, a benzoxazole ring, a 2-quinoline ring, a 4-quinoline ring and an indolenine ring are particularly preferred.

Preferable examples of the substituent on Q_{b} include: a carboxyl group; a phosphonyl group; a sulfonyl group; halogen atoms such as F, Cl, Br and I; a cyano group; an alkoxy group such as a methoxy group, an ethoxy group and a methoxyethoxy group; an aryloxy group such as a phenoxy group; an alkyl group such as a methyl group, an ethyl group, a cyclopropyl group, a cyclohexyl group, a trifluoromethyl group, a methoxyethyl group, an allyl group and a benzyl group; an alkylthio group such as a methylthio group and an ethylthio group; an alkenyl group such as a vinyl group and a 1-propenyl group; an aryl group such as a phenyl group, a chlorophenyl group and toluyl group; a heterocyclic group such as a thienyl group; etc.

Z_{b} is preferably composed of atoms selected from the group consisting of carbon, oxygen, nitrogen, sulfur and hydrogen atoms. The ring formed by Z_{b} is preferably a ring with a 4 to 6 carbon skeleton, more preferably such that represented by any one of the following (a) to (e), the most preferably such that represented by (a).

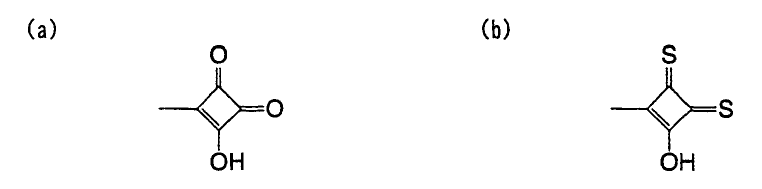

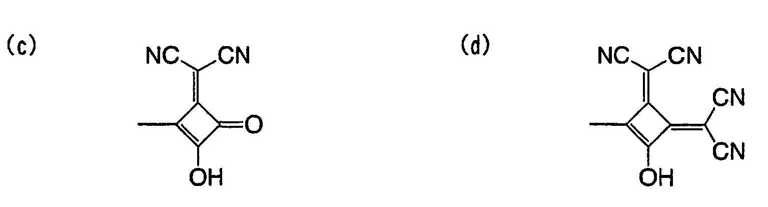

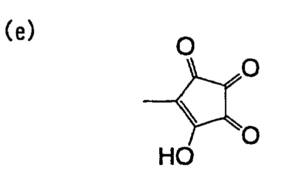

Examples of the substituent on L₆₁ to L₆₅ include: a substituted or unsubstituted alkyl group having preferably 1 to 12 carbon atom, more preferably 1 to 7 carbon atom, such as a methyl group, an ethyl group, a propyl group, an isopropyl group, a cyclopropyl group, a butyl group, a 2-carboxyethyl group and a benzyl group; a substituted or unsubstituted aryl group preferably having 6, 8 or 10 carbon atoms, more preferably 6 or 8 carbon atoms, such as a phenyl group, a tolyl group, a chlorophenyl group and an o-carboxyphenyl group; a heterocyclic group such as a pyridyl group, a thienyl group, a furanyl group and a barbituric acid group; a halogen atom such as a chlorine atom and a bromine atom; an alkoxy group such as a methoxy group and an ethoxy group; an amino group having preferably 1 to 12, more preferably 6 to 12 carbon atoms, such as a diphenylamino group, a methylphenylamino group and a 4-acetylpiperazine-1-yl group; an oxo group; etc. The substituents may be bonded together to form a cyclopentene ring, a cyclohexene ring, a squalilium ring, etc. Further, the substituents may combine an auxochrome to form a ring.

The substituent represented by R₈₁ is preferably an aliphatic group that may have a substituent or an aromatic group that may have a substituent. The aliphatic group has preferably 1 to 10, more preferably 1 to 6 carbon atom. The aromatic group has preferably 1 to 16 carbon atom, more preferably 5 or 6 carbon atoms. Examples of the unsubstituted aliphatic group and aromatic group include a methyl group, an ethyl group, a *n*-propyl group, a *n*-butyl group, a phenyl group and a naphthyl group.

Whether the dye is a cation or an anion, and whether it has the net ionic charge or not depends on the auxochrome and substituents thereof. The charge of the entire dye molecule is neutralized by a counter ion X₄. Typical positive counter ions are inorganic or organic ammonium ions such as a tetralkyl ammonium ion, a pyridinium ion, etc. and alkali metal ions. On the other hand, negative counter ions may be inorganic or organic, and examples thereof include: a halide ion such as a fluoride ion, a chloride ion, a bromide ion and an iodide ion; a substituted aryl sulfonate ion such as a *p*-toluene sulfonate ion and a *p*-chlorobenzene sulfonate ion; an aryl disulfonate ion such as a 1,3-benzene disulfonate ion, a 1,5-naphthalene disulfonate ion and a 2,6-naphthalene disulfonate ion; an alkyl sulfate ion such as a methyl sulfate ion; a sulfate ion; a thiocyanate ion; a perchlorate ion; a tetrafluoroborate ion; a picrate ion; an acetate ion; a trifluoromethane sulfonate ion; etc.

Further, ionic polymers or other dyes having an opposite charge to the dye may be also used as a charge-balancing counter ion. Alternatively, metal complex such as bisbenzene-1,2-dithiolato nickel (III) can be also used in the present invention.

### 4. General Formula (V)

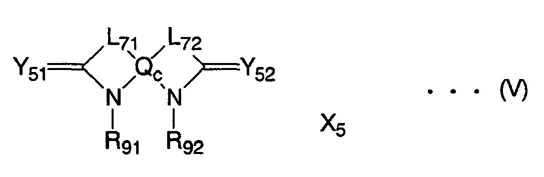

In the general formula (V), Q_{c} represents an at least tetravalent aromatic group; and L₇₁ and L₇₂ independently represent a sulfur atom, a selenium atom or -CRR'- (in which R and R' independently represent a hydrogen atom or an alkyl group, and may be the same or different group). L₇₁ and L₇₂ are preferably a sulfur atom or -CRR'-, more preferably -CRR'-, respectively. R₉₁ and R₉₂ independently represent an alkyl group or an aromatic group, and Y₅₁ and Y₅₂ independently represent a non-metal atomic group necessary to act as a polymethine dye. X₅ represents a counter ion.

Q_{c} may be derived from an aromatic hydrocarbon such as benzene, naphthalene, anthracene and phenanthrene, an aromatic heterocyclic ring such as anthraquinone, carbazole, pyridine, quinoline, thiophene, furan, xanthene and thianthrene, etc. The aromatic group Q_{c} may have a substituent. Q_{c} is derived from preferably aromatic hydrocarbon, more preferably benzene or naphthalene.

Various kinds of methine dyes can be formed by Y₅₁ and Y₅₂. It is preferable that Y₅₁ and Y₅₂ form a cyanine dye, a merocyanine dye, a rhodacyanine dye, a trinuclear merocyanine dye, an allopolar dye, a hemicyanine dye or a styryl dye. Herein, the cyanine dyes include such that having substituents that forms a squalium ring, a croconium ring, etc. on the methine chain. Details of the dyes represented by the general formula (V) are described in: F. M. Harmer, "Heterocyclic Compounds -Cyanine Dyes and Related Compounds", John Wiley & Sons, New York, London (1964); D. M. Sturmer, "Heterocyclic Compounds -Special Topics in Heterocyclic Chemistry", Chapter 18, Section 14, page 482 to 515, John Wiley & Sons, New York, London (1977); etc. Among the cyanine dyes, the merocyanine dyes and the rhodacyanine dyes, preferred are such that described in United States Patent No. 5,340,694, chapter (XI), (XII) and (XIII), page 21 to 22. The dye represented by the general formula (V) has a squalilium ring on preferably at least one methine chain, more preferably the both methine chains.

R₉₁ and R₉₂ are independently an aliphatic group or an aromatic group, which may have a substituent. The aliphatic group has preferably 1 to 10 carbon atom, more preferably 1 to 6 carbon atom. The aromatic group has preferably 5 to 16 carbon atoms, more preferably 5 or 6 carbon atoms. Examples of the unsubstituted aliphatic group and aromatic group include a methyl group, an ethyl group, a *n*-propyl group, a *n*-butyl group, a phenyl group and a naphthyl group.

It is preferable that at least one of R₉₁, R₉₂, Y₅₁ and Y₅₂ has an acidic group. The acidic group is a group with a dissociative proton, such as a carboxylic acid group, a phosphonic acid group, a sulfonic acid group, a boric acid group, etc. Among them, preferred is a carboxylic acid group. The dissociative proton of the acidic group may be dissociated.

The specific examples (1) to (43) and S-1 to S-42 of the polymethine dyes represented by any of the general formulae (II) to (V) will be illustrated below without intention of restricting the scope of the present invention defined by the claims attached hereto.

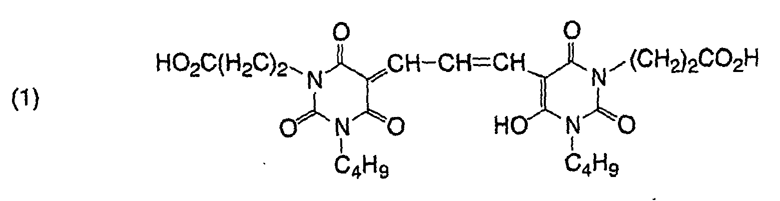

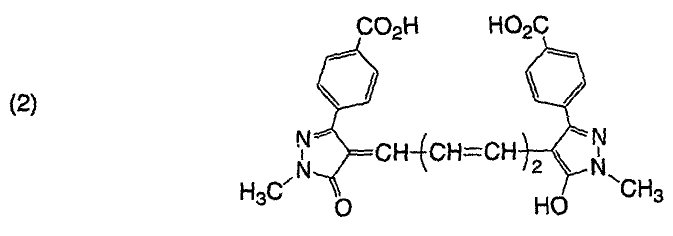

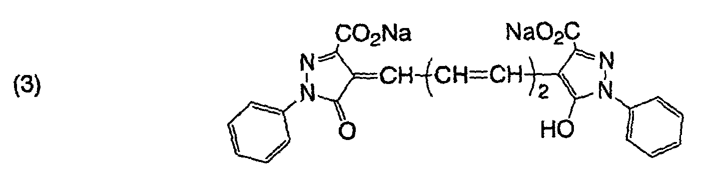

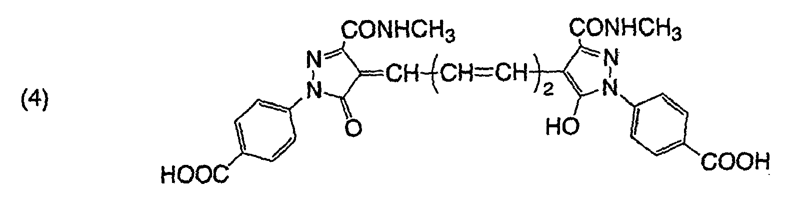

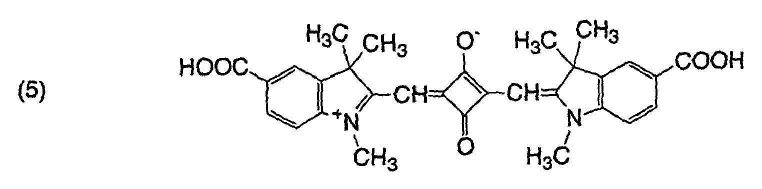

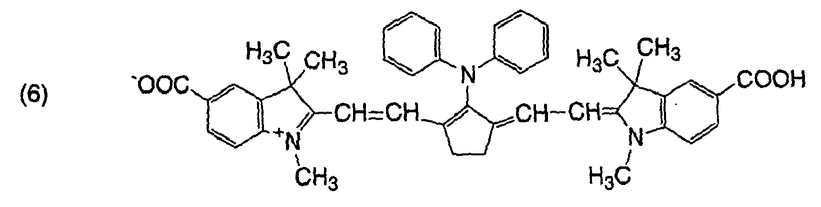

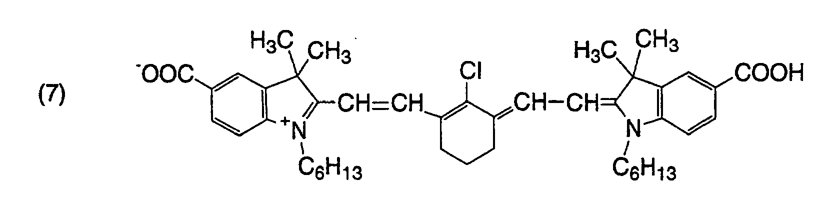

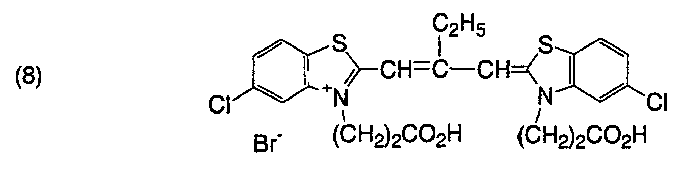

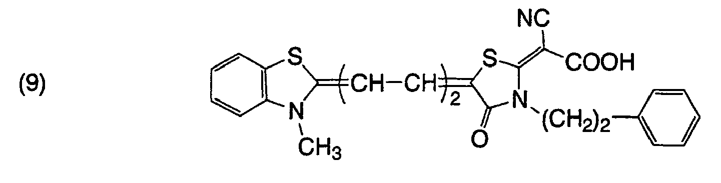

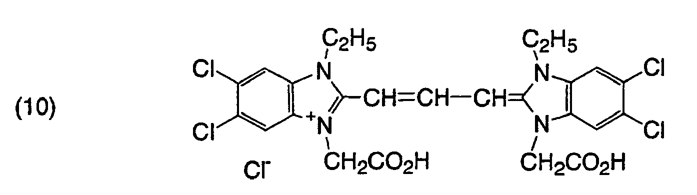

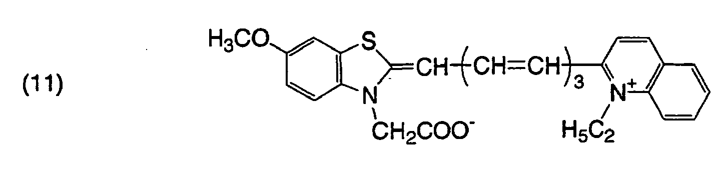

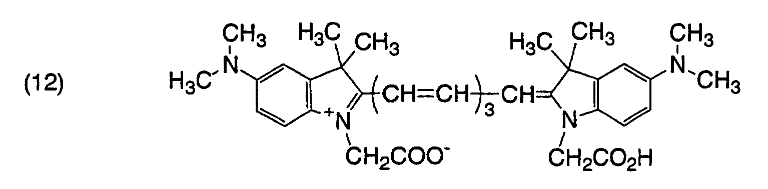

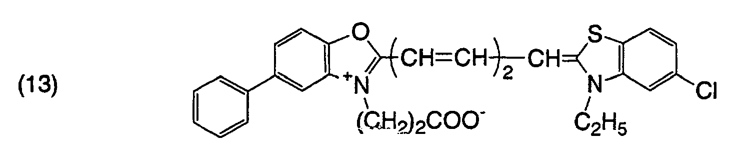

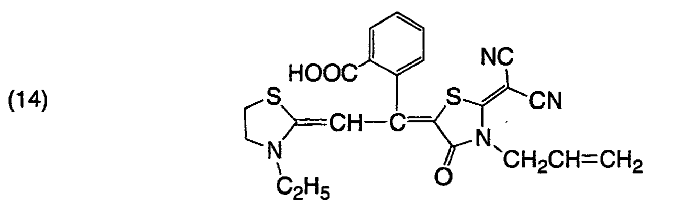

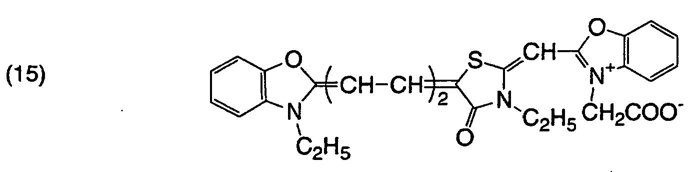

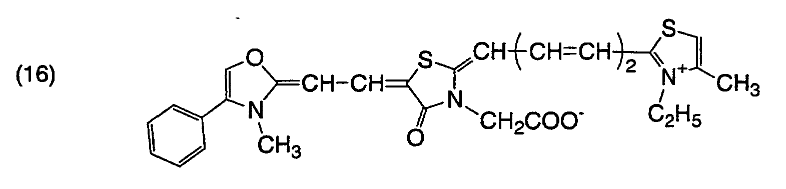

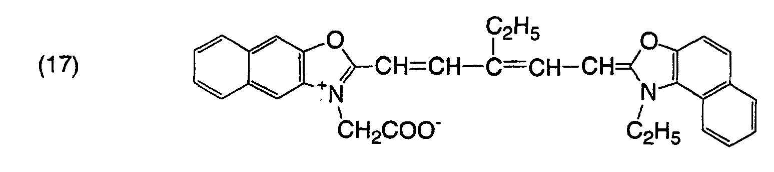

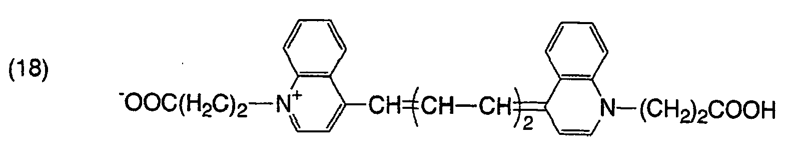

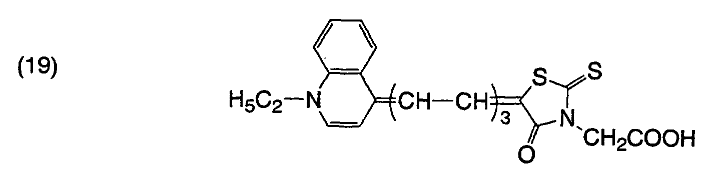

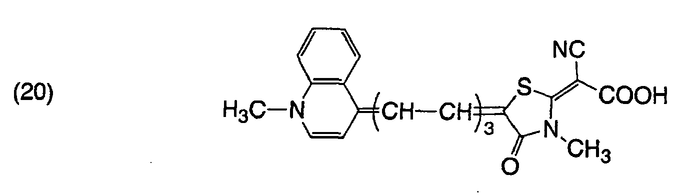

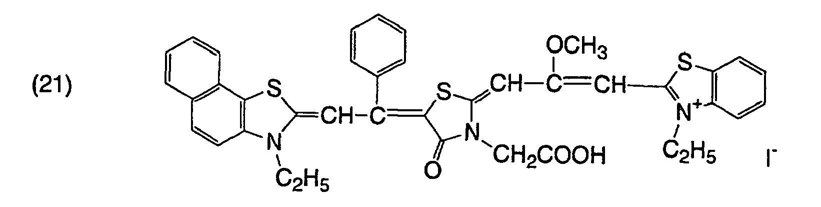

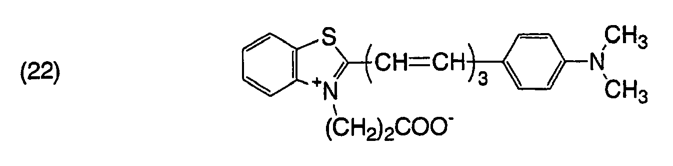

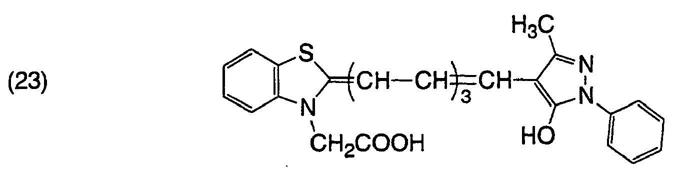

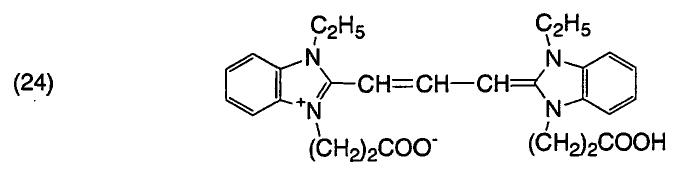

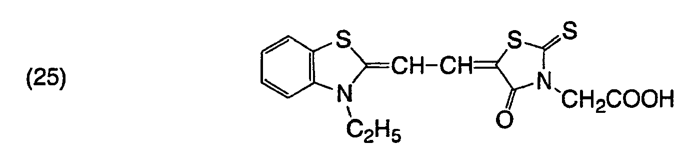

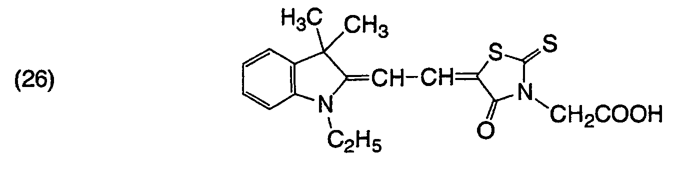

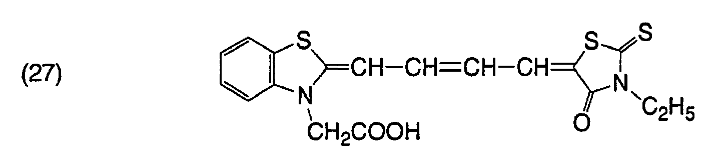

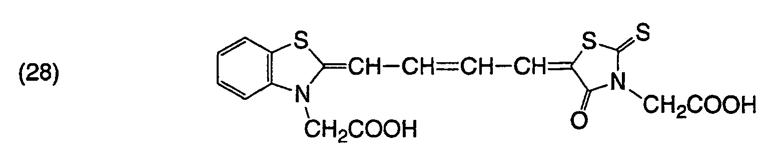

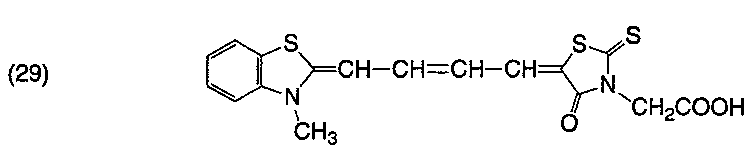

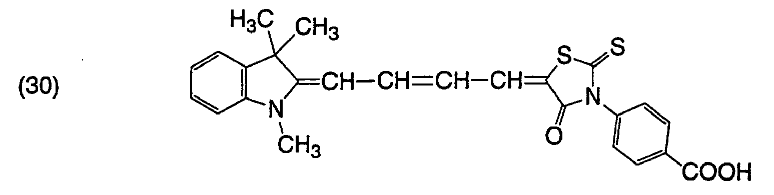

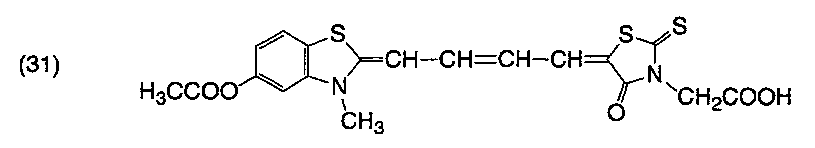

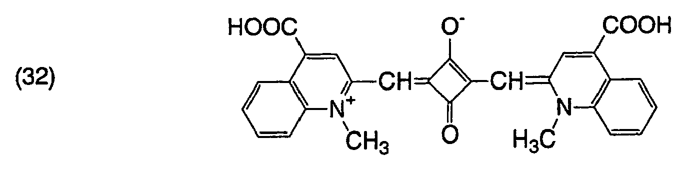

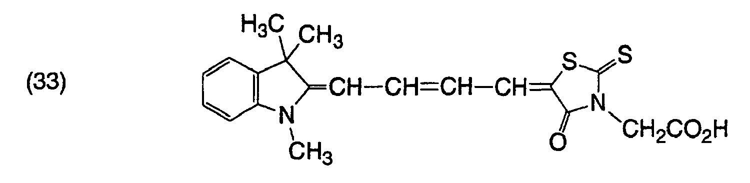

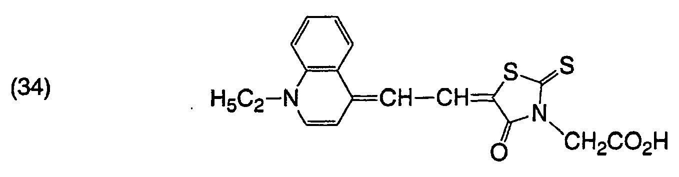

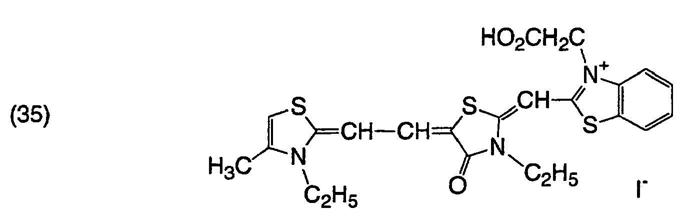

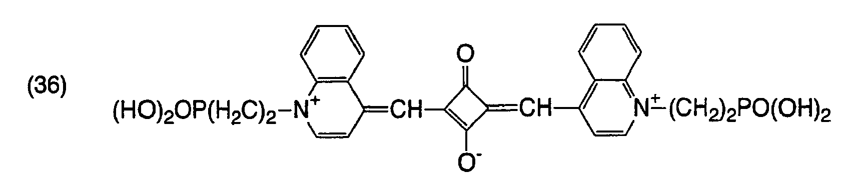

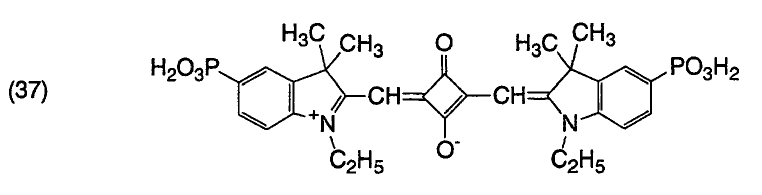

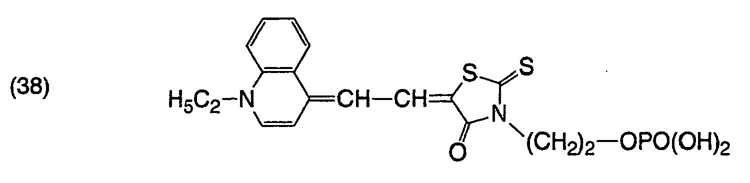

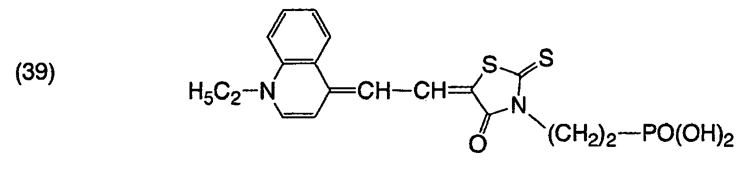

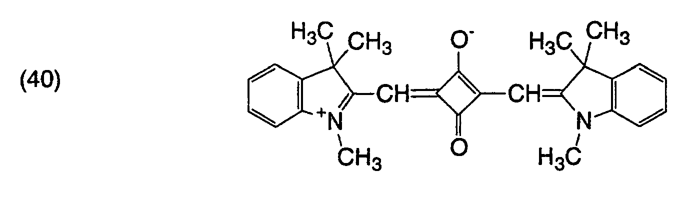

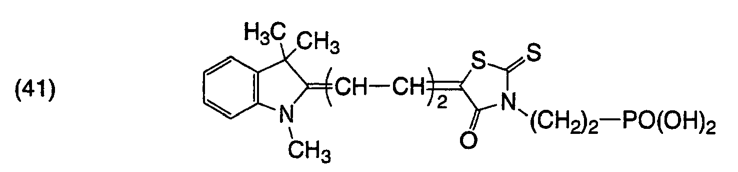

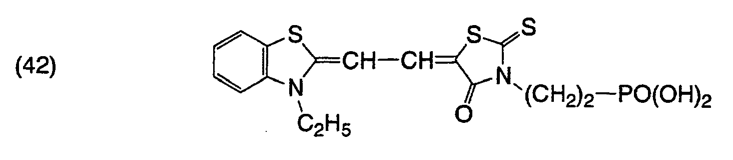

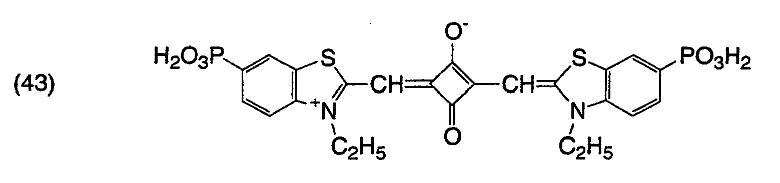

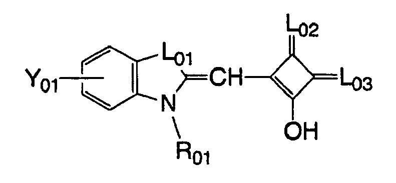

| Dye | Y₀₁ | R₀₁ | L₀₁ | L₀₂ | L₀₃ |
|---|---|---|---|---|---|
| S-1 | 4,5-Benzo | C₃H₇ | C(CH₃)₂ | O | O |
| S-2 | H | (CH2)₃COOH | C(CH₃)₂ | O | O |
| S-3 | 4,5-Benzo | C₂H₅ | C(CH₃)₂ | S | S |
| S-4 | 4,5-Benzo | C₂H₅ | C(CH₃)₂ | C(CN)₂ | O |
| S-5 | 4,5-Benzo | C₂H₅ | C(CH₃)₂ | C(CN)₂ | C(CN)₂ |
| S-6 | H | C₂H₅ | S | O | O |
| S-7 | 5,6-Benzo | CH₃ | S | O | O |
| S-8 | H | CH₃ | O | O | O |
| S-9 | H | CH₃ | Se | O | O |
| S-10 | H | CH₃ | N(C₂H₅) | O | O |
| S-11 | H | C₂H₅ | -CH=CH- | O | O |

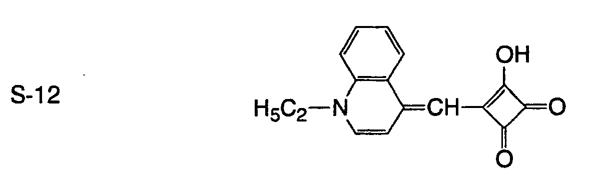

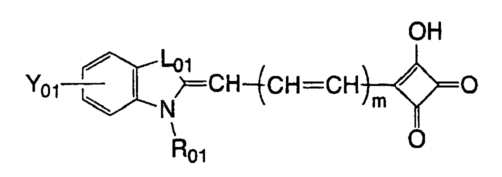

| Dye | Y₀₁ | R₀₁ | L₀₁ | m |
|---|---|---|---|---|
| S-13 | H | CH₃ | C(CH₃)₂ | 1 |
| S-14 | 4,5-Benzo | C₂H₅ | C(CH₃)₂ | 1 |
| S-15 | H | CH₃ | S | 2 |
| S-16 | 5,6-Benzo | C₂H₅ | S | 3 |
| S-17 | 5,6-Benzo | C₂H₅ | S | 4 |
| S-18 | H | CH₃ | O | 1 |

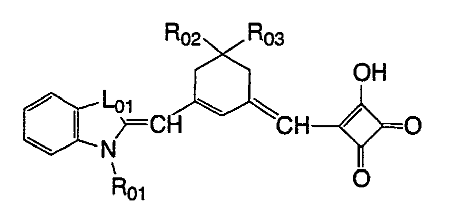

| Dye | R₀₁ | R₀₂ | R₀₃ | L₀₁ |
|---|---|---|---|---|
| S-19 | C₂H₅ | CH₃ | CH₃ | C(CH₃)₂ |
| S-20 | C₂H₅ | CH₃ | CH₃ | S |
| S-21 | (CH₂)₃COOH | CH₃ | CH₃ | O |
| S-22 | C₂H₅ | Ph | H | O |

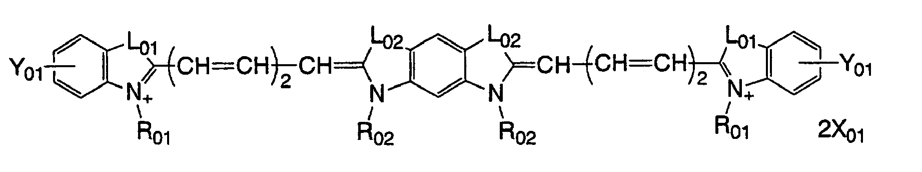

| Dye | Y₀₁ | R₀₁ | R₀₂ | L₀₁ | L₀₂ | X₀₁ |
|---|---|---|---|---|---|---|
| S-23 | H | CH₃ | CH₃ | S | S | I⁻ |
| S-24 | 5-COOH | C₂H₅ | CH₃ | S | S | I⁻ |
| S-25 | 5-COOH | CH₃ | CH₃ | C(CH₃)₂ | C(CH₃)₂ | I⁻ |
| S-26 | H | (CH2)₂COOH | C₂H₅ | C(CH₃)₂ | C(CH₃)₂ | CI⁻ |
| S-27 | H | CH₃ | C₂H₅ | C(CH₃)₂ | O | I⁻ |

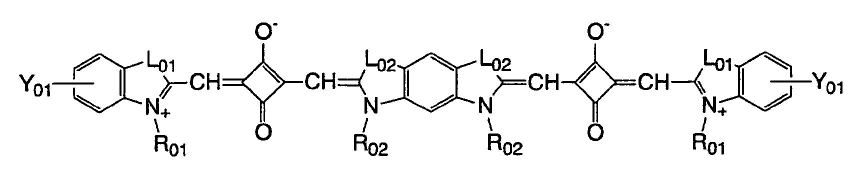

| Dye | Y₀₁ | R₀₁ | R₀₂ | L₀₁ | L₀₂ |
|---|---|---|---|---|---|
| S-28 | H | CH₃ | CH₃ | C(CH₃)₂ | S |
| S-29 | 4,5-Benzo | C₃H₇ | CH₃ | C(CH₃)₂ | S |
| S-30 | 5-COOH | CH₃ | CH₃ | S | C(CH₃)₂ |
| S-31 | 5-COOH | CH₃ | CH₃ | C(CH₃)₂ | C(CH₃)₂ |
| S-32 | 5-CH₃ | CH₃ | C₂H₅ | N(CH₃) | C(CH₃)₂ |

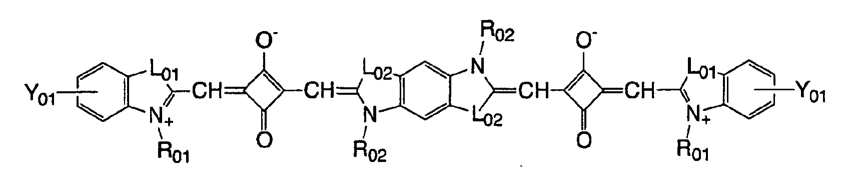

| Dye | Y₀₁ | R₀₁ | R₀₂ | L₀₁ | L₀₂ |
|---|---|---|---|---|---|
| S-33 | H | CH₃ | CH₃ | C(CH₃)₂ | S |
| S-34 | 5-SO₃H | C₂H₅ | CH₃ | C(CH₃)₂ | S |
| S-35 | 5-COOH | CH₃ | C₂H₅ | C(CH₃)₂ | C(CH₃)₂ |
| S-36 | 4,5-Benzo | (CH2)₂COOH | CH₃ | C(CH₃)₂ | C(CH₃)₂ |
| S-37 | 5-CH₃ | CH₃ | C₂H₅ | NCH₃ | C(CH₃)₂ |

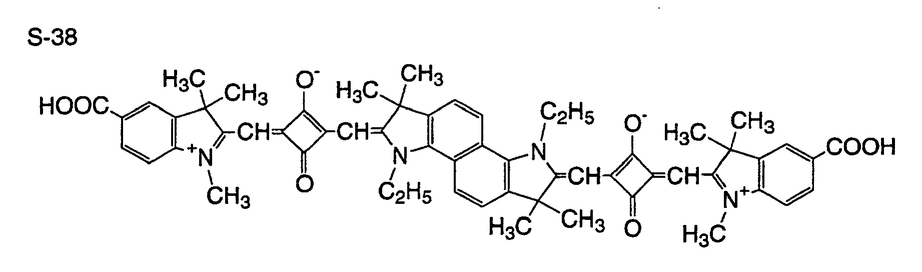

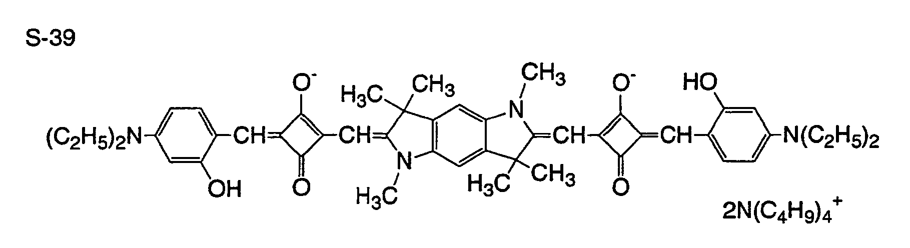

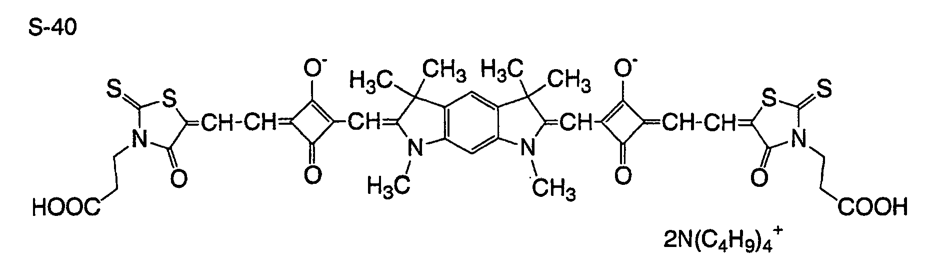

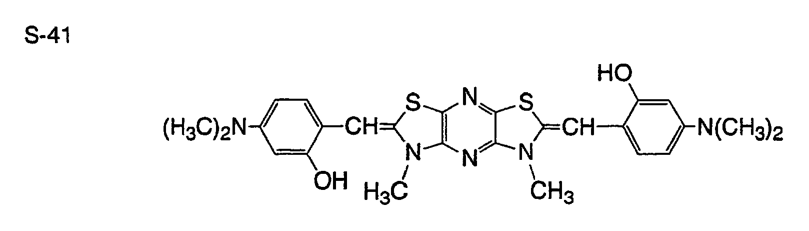

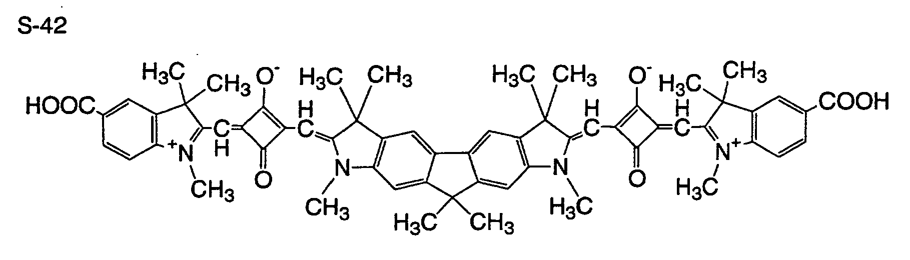

The dyes represented by the formulae (II) and (III) can be synthesized by the methods described in: F. M. Harmer, "Heterocyclic Compounds -Cyanine Dyes and Related Compounds", John Wiley & Sons, New York, London (1964); D. M. Sturmer, "Heterocyclic Compounds -Special Topics in Heterocyclic Chemistry", Chapter 18, Section 14, page 482 to 515, John Wiley & Sons, New York, London (1977); "Rodd's Chemistry of Carbon Compounds", 2nd. Ed., Vol. IV, Part B, Chapter 15, page 369 to 422, Elsevier Science Publishing Company Inc., New York (1977); British Patent No. 1,077,611; etc. The dyes represented by the formula (IV) can be synthesized based on the methods described in Dyes and Pigments, Vol. 21, page 227 to 234, etc. The dyes represented by the formula (V) can be synthesized based on: Ukrainskii Khimicheskii Zhurnal, Vol. 40, No. 3, page 253 to 258; Dyes and Pigments, Vol. 21, page 227 to 234; and references therein.

### (4) Adsorption of Dye to Semiconductor Fine Particles

The dye may be adsorbed to the semiconductor fine particles by soaking the conductive support having the well-dried semiconductor fine particle layer in a dye solution, or by coating the dye solution to the semiconductor fine particle layer. In the former case, a soaking method, a dipping method, a roller method, an air-knife method, etc. may be used. In the soaking method, the dye may be adsorbed at a room temperature or while refluxing as described in Japanese Patent Laid-Open No. 7-249790. As a coating method of the latter, a wire-bar method, a slide-hopper method, an extrusion method, a curtain method, a spin method, a spray method, etc. may be used. As a printing method, a relief printing, an offset printing, a gravure printing, a screen-printing, etc. may be used.

A solvent for the dye solution may be properly selected in accordance with the solubility of the dye. For example, alcohols such as methanol, ethanol, *t*-butanol, benzyl alcohol, etc.; nitriles such as acetonitrile, propionitrile, 3-methoxypropionitrile, etc.; nitromethane; halogenated hydrocarbons such as dichloromethane, dichloroethane, chloroform, chlorobenzene, etc.; ethers such as diethylether, tetrahydrofuran, etc.; dimethylsulfoxide; amides such as *N,N-*dimethylformamide, *N,N*-dimethylacetamide, etc.; *N*-methylpyrrolidone; 1,3-dimethylimidazolidinone; 3-methyloxazolidinone; esters such as ethyl acetate, butyl acetate, etc.; carbonates such as diethyl carbonate, ethylene carbonate, propylene carbonate, etc.; ketones such as acetone, 2-butanone, cyclohexanone, etc.; hydrocarbons such as hexane, petroleum ether, benzene, toluene, etc.; and mixtures thereof may be used.

As is similar to the case of forming the semiconductor fine particle layer, an extrusion method and various kinds of printing methods are suitable for a high viscosity dye solution (e.g. 0.01 to 500 Poise), and a slide-hopper method, a wire bar method and a spin method are suitable for a low viscosity dye solution (e.g. 0.1 Poise or less) to form a uniform film.

Thus, the dye adsorption method may be properly selected in accordance with the viscosity of the dye solution, the coating amount, the conductive support, the coating speed, etc. It is preferable that the dye-adsorbing time after coating is as short as possible from a viewpoint of mass production.

The unadsorbed dyes are preferably removed by washing immediately after adsorption because they often cause disturbance of efficiency of the device. The washing is preferably carried out using a wet type washing bath with a polar solvent such as acetonitrile, or an organic solvent such as an alcohol-based solvent. To enhance the adsorption amount of the dye, a heat treatment is preferably carried out before the adsorption. After the heat treatment, it is preferable that the dye is quickly adsorbed at 40 to 80 ° C without cooling to a room temperature to prevent adsorption of water onto the surface of the semiconductor fine particles.

The total amount of the dye is preferably 0.01 to 100 mmol per the unit surface area (1 m²) of the conductive support. The amount of the dye adsorbed to the semiconductor fine particles is preferably 0.01 to 1 mmol per 1 g of the semiconductor fine particles. Such an adsorption amount of the dye effects a sufficient sensitization to the semiconductors. In contrast, if the amount of the dye is too small, the sensitization effect is not sufficient. On the other hand, if it is excessive, the dye unadsorbed to the semiconductor fine particles floats to reduce sensitization effect.

Two or more kinds of dyes may be mixed and used for the photoelectric conversion device to extend the conversion wavelength range and to increase a conversion efficiency. In this case, kinds and proportion of the dyes are preferably selected in accordance with the wavelength region and the intensity distribution of a light source.

A colorless compound may be co-adsorbed onto the semiconductor fine particles together with the dye to weaken an interaction, such as association, between the dyes. As a hydrophobic compound used for the co-adsorption, a steroid compound having a carboxyl group such as chenodeoxycholic acid, etc. may be used. A UV-absorbing agent may be used together therewith.

The surface of the semiconductor fine particles may be treated with amines after dye adsorption to accelerate to remove an excessive dye. Preferable examples of the amines include pyridine, 4-*t*-butylpyridine, polyvinylpyridine, etc. The amine may be used as a solution of an organic solvent, and may be used singly when it is liquid.

### (C) Charge Transfer Layer

The charge transfer layer replenishes electrons to the oxidized dye. The charge transfer layer comprises the electrolyte composition of the present invention mentioned above. A solid electrolyte and a hole-transporting material may be also contained in the charge transfer layer.

The charge transfer layer comprising the electrolyte composition of the present invention is preferably formed by applying the electrolyte composition to the photosensitive layer, and by heating the applied composition to cross-linking it, if necessary. Application of the electrolyte composition may be achieved by a casting method, a coating method, a soaking method, a loading method, etc.

In the case of the coating method, the charge transfer layer may be formed by the method comprising the steps of: preparing the uniform electrolyte composition comprising the electrolyte salt, additives such as a coating quality-improving agent (a leveling agent, etc.), etc.; coating the composition by a spin coating method, a dip coating method, an air-knife coating method, a curtain coating method, a roller coating method, a wire-bar coating method, a gravure coating method, an extrusion coating method using a hopper described in United States Patent No. 2,681,294, a simultaneous multi-layer coating method described in United States Patent Nos. 2,761,418, 3,508,947 and 2,761,791; and heating the coated composition, if necessary. The heating temperature is properly selected in accordance with a heat-resistance of the dye, etc. The temperature is preferably 10 to 150 °C, more preferably 10 to 100 °C in general. The heating time, depending on the heating temperature, etc., may be approximately 5 minutes to 72 hours.

According to the preferable embodiment of the present invention, the electrolyte composition is coated in a more amount than that required to completely fulfill voids in the photosensitive layer. Therefore, as shown in Fig. 1, the resulting electrolyte composition layer substantially exists from the surface of the electrically conductive layer 10 to the surface of the counter electrically conductive layer 40. If the charge transfer layer 30 is defined as the electrolyte composition layer existing from the surface of the photosensitive layer 20 to the surface of the counter electrically conductive layer 40, the thickness of the charge transfer layer 30 is preferably 0.001 to 200 µm, more preferably 0.1 to 100 µm, particularly preferably 0.1 to 50 µm. When the charge transfer layer 30 has thickness of less than 0.001 µm, there is a fear that the semiconductor fine particles 21 in the photosensitive layer 20 comes in contact with the counter electrically conductive layer 40. On the other hand, when the thickness is more than 200 µm, the charge transfer distance becomes so large that the resistance of the device is increased. Incidentally, the total thickness of the photosensitive layer 20 and the charge transfer layer 30, which is substantially equal to the thickness of the electrolyte composition layer, is preferably 0.1 to 300 µm, more preferably 1 to 130 µm, particularly preferably 2 to 75 µm.

To form an oxidation-reduction pair in the electrolyte composition, iodine, etc. may be introduced thereinto by: adding iodine, etc. to the electrolyte composition before forming the charge transfer layer; placing the conductive support disposed the charge transfer layer thereon in a sealed vessel with iodine, etc. to diffuse it into the charge transfer layer; etc. Further, iodine, etc. may be coated or vapor-deposited on the counter electrode before constituting the photoelectric conversion device, to introduce it to the charge transfer layer

### (D) Counter Electrode

When the photoelectric conversion device of the present invention is applied to the photo-electrochemical cell, the counter electrode acts as an anode. The counter electrode may be a single layer of the counter electrically conductive layer of an electrically conductive material, or two layers of the counter electrically conductive layer and the substrate, as is similar to the above-described conductive support. The conductive material for the counter electrically conductive layer may be: a metal such as platinum, gold, silver, copper, aluminum, rhodium and indium; carbon; or an electrically conductive metal oxide such as indium-tin composite oxide and fluorine-doped tin oxide. The substrate for the counter electrode is preferably made of glass or plastic, the counter electrically conductive layer being coated or vapor-deposited thereon.

The thickness of the counter electrically conductive layer is not particularly limited, preferably 3 nm to 10 µm. In the case of the metal counter electrically conductive layer, the thickness thereof is preferably 5 µm or less, more preferably 5 nm to 3 µm.

A light may be irradiated from any one or both side of the conductive support and the counter electrode, so that at least one of them must be substantially transparent to have light reached to the photosensitive layer. From a viewpoint of improving electric generation efficiency, it is preferable that the conductive support is transparent to irradiate light therethrough. In this case, the counter electrode preferably has a light-reflective property. Such a counter electrode may be composed of a substrate of glass, plastic or metal, and a vapor-deposited layer of metal or electrically conductive oxide disposed on the substrate.

The counter electrode may be disposed (i) on the charge transfer layer formed beforehand, or (ii) on the photosensitive layer through a spacer before forming the charge transfer layer. In the case of (i), the counter electrode may be disposed by: directly coating, metal-plating, or vapor-depositing (PVD, CVD, etc.) the electrically conductive material on the charge transfer layer; or laminating the electrically conductive layer formed on the substrate on the charge transfer layer. In the case of (ii), the counter electrode is disposed and fixed on the photosensitive layer through the spacer, and the open ends therebetween is soaked in the electrolyte composition. The electrolyte composition penetrates into the voids between the counter electrode and the photosensitive layer by capillarity or reduced pressure.

Similar to the case of the conductive support, it is preferable to use the metal lead for reducing the resistance of the electrode particularly in the case of the transparent counter electrode. Preferable embodiments of the metal lead are the same as those in the case of the conductive support mentioned above.

### (E) Others

Functional layers such as a protective layer and a reflection-preventing layer may be disposed on any one or both of the conductive support and the counter electrode each acting as the electrode. Such functional layers may be formed in a fashion of multi-layers by a simultaneous multi-layer coating method or a successive coating method. Of these methods, the simultaneous multi-layer coating method is preferred from a viewpoint of productivity. As for the simultaneous multi-layer coating method, a slide-hopper method and an extrusion method are preferable from the viewpoint of the productivity and homogeneity of a coated film. The functional layers may be disposed by a method selected in accordance with the materials therefor, such as a vapor-deposition method and a sticking method.

An undercoating layer, which may be composed of a semiconductor thin film, may be disposed between the conductive support and the photosensitive layer to prevent short-circuit of the device. Preferable materials therefor include TiO₂, SnO₂, Fe₂O₃, WO₃, ZnO and Nb₂O₅. Among them, TiO₂ is more preferred. The undercoating layer may be disposed by a spray-pyrolysis method described in Electrochim. Acta, 40, 643 to 652 (1995). The thickness of the undercoating layer is preferably 5 to 1000 nm, more preferably 10 to 500 nm.

### (F) Interior Structure of Photoelectric Conversion Device

As described above, the photoelectric conversion device may have various interior structures in accordance with an end of use. The structures are classified into two major forms, a structure allowing light incidence from both faces, and a structure allowing it from only one face. Each of Fig. 2 to 8 illustrates an example of the interior structure of the photoelectric conversion device, which is preferable in the present invention.

As for the structure illustrated in Fig. 2, the photosensitive layer 20 and the charge transfer layer 30 are disposed between the transparent electrically conductive layer 10a and the transparent counter electrically conductive layer 40a. This structure allows light incidence from both faces of the device.

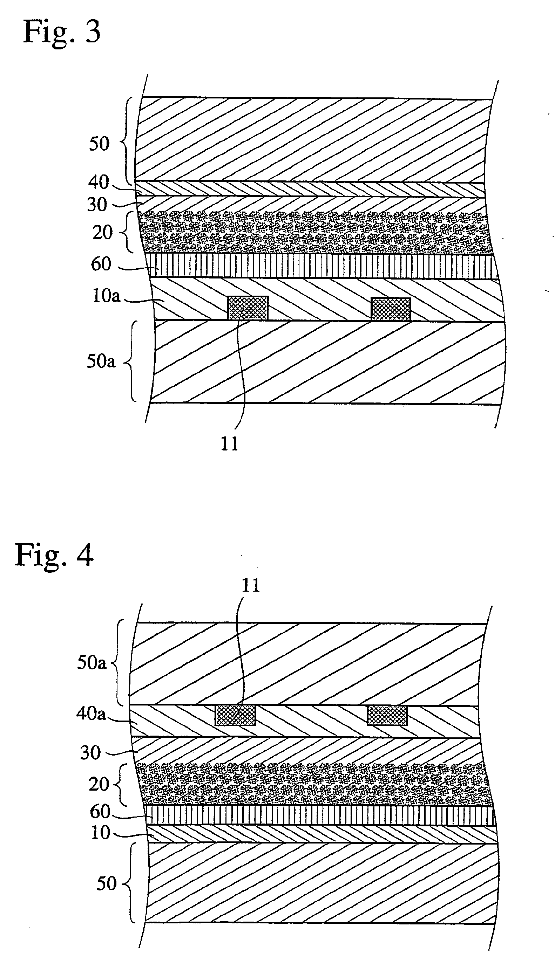

As for the structure illustrated in Fig. 3, on the transparent substrate 50a partially having the metal lead 11 is disposed the transparent electrically conductive layer 10a, the undercoating layer 60, the photosensitive layer 20, the charge transfer layer 30 and the counter electrically conductive layer 40 are laminated in this order, and the substrate 50 is further placed thereon. This structure allows light incidence from the electrically conductive layer side.

As for the structure illustrated in Fig. 4, the photosensitive layer 20 is disposed on the substrate 50 having the electrically conductive layer 10 through the undercoating layer 60, the charge transfer layer 30 and the transparent counter electrically conductive layer 40a are disposed thereon, and further the transparent substrate 50a locally having the metal lead 11 is placed on the counter electrically conductive layer 40a so that the metal lead 11 side orients inward. This structure allows light incidence from the counter electrode side.

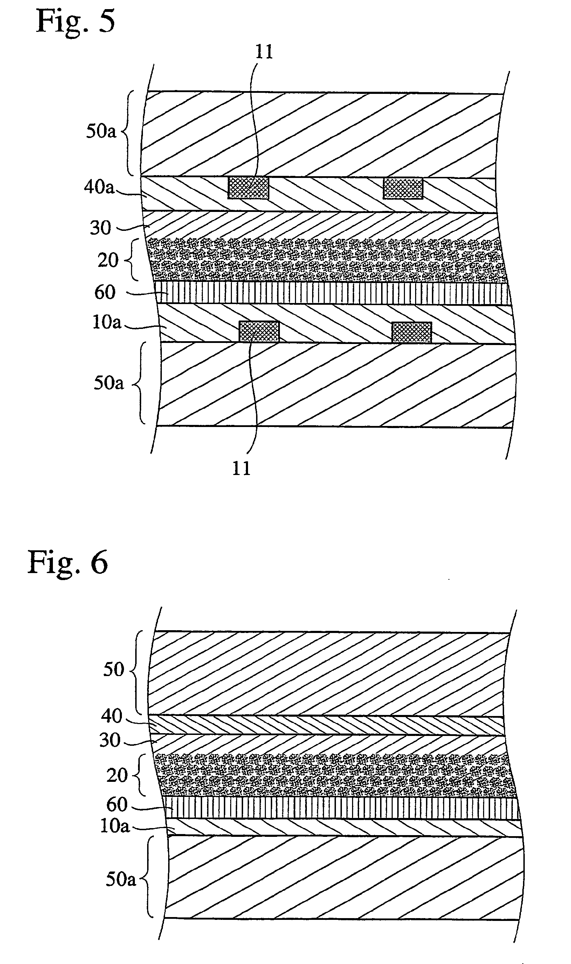

As for the structure illustrated in Fig. 5, on the two transparent substrates 50a each having the metal lead 11 partially are formed the transparent electrically conductive layer and the transparent counter electrically conductive layer 40a, respectively, and the undercoating layer 60, the photosensitive layer 20 and the charge transfer layer 30 placed between the conductive layers. This structure allows light incidence from both faces of the photoelectric conversion device.

As for the structure illustrated in Fig. 6, on the transparent substrate 50a having the transparent electrically conductive layer 10a is disposed the photosensitive layer 20 through the undercoating layer 60, the charge transfer layer 30 and the counter electrically conductive layer 40 are formed thereon, and further the substrate 50 is placed on the counter electrically conductive layer 40. This structure allows light incidence from the electrically conductive layer side.

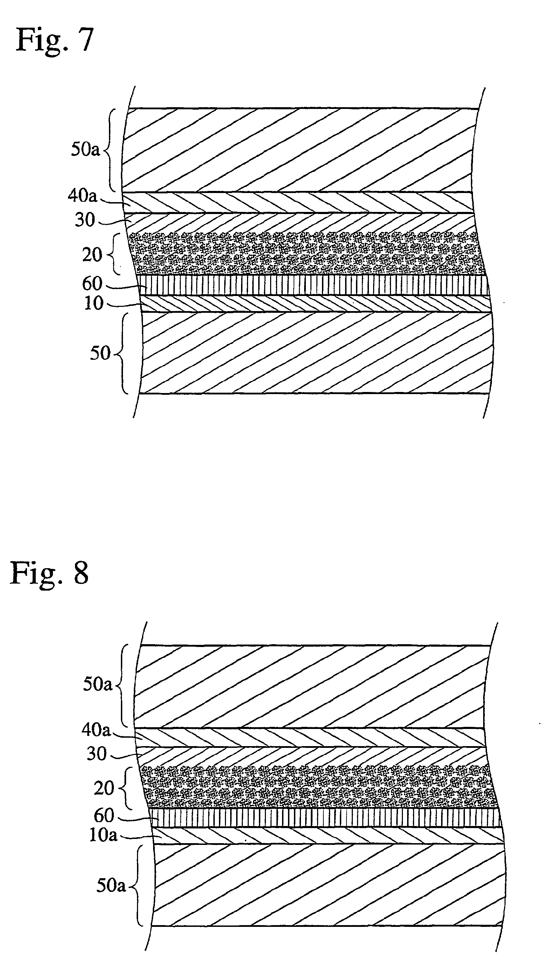

As for the structure illustrated in Fig. 7, on the substrate 50 having the electrically conductive layer 10 is disposed the photosensitive layer 20 through the undercoating layer 60, the charge transfer layer 30 and the transparent counter electrically conductive layer 40a are formed thereon, and further the transparent substrate 50a is placed on the layer 40a. This structure allows light incidence from the counter electrode side.

As for the structure illustrated in Fig. 8, on the transparent substrate 50a having the transparent electrically conductive layer 10a is disposed the photosensitive layer 20 through the undercoating layer 60, the charge transfer layer 30 and the transparent counter electrically conductive layer 40a are formed thereon, and further the transparent substrate 50a is placed on the layer 40a. This structure allows light incidence from both faces of the photoelectric conversion device.

### [3] Photo-Electrochemical Cell

The photo-electrochemical cell of the present invention comprises the above-described photoelectric conversion device designed to work in the outer circuit. The side face of the photo-electrochemical cell is preferably sealed with a polymer or an adhesive agent, etc. to prevent deterioration and volatility of the content in the cell. The outer circuit is connected to the conductive support and the counter electrode via a lead. Various known circuits may be used in the present invention.

### [4] Dye-Sensitized Solar Cell

In the case where the photoelectric conversion device of the present invention is applied to so-called solar cell, the interior structure of the solar cell may be essentially the same as that of the photoelectric conversion device mentioned above. Module structures of the solar cell comprising the photoelectric conversion device of the present invention will be explained below.

The dye-sensitized solar cell may have the same module structure as that of prior art solar cells. The solar cell module generally has a structure where cells are placed on a substrate of metal, ceramic, etc. and covered with a packing resin, a protective glass, etc. Light is introduced from the opposite side of the substrate. The solar cell module may also have a structure where the cells are placed on a substrate of a transparent material such as a tempered glass to introduce light from the transparent substrate side. Specifically, a superstraight type module structure, a substrate type module structure, a potting type module structure, substrate-integrated type module structure that is generally used in amorphous silicon solar cells, etc. are known as the solar cell module structure. The dye-sensitized solar cell comprising the photoelectric conversion device of the present invention may have a module structure properly selected from the above structures in accordance with ends, environment at use.

The super straight type module and the substrate type module generally have a structure where the cells are placed at a regular intervals between substrates and connected by a metal lead, a flexible wirering, etc., and collector electrodes are placed at the outer marginal portion to deliver generated electric power to the outside. The substrate is subjected to a reflection-preventing treatment, and any one or both side thereof is transparent. Between the substrate and the cell may be disposed various kinds of plastic material such as ethylene vinyl acetate (EVA) to protect the cell or to improve a collector efficiency. Such a plastic material is may be used in a form of a film or a packing resin. In the case where the solar cell is used at a place where the surface of the cell is not necessarily covered with a hard material, such as a place without a shock from the outside, one of the substrate can be omitted by forming a surface protective layer of a transparent plastic film, or by hardening the above-described packing resin to protect the cell. To secure rigidity of the module, the periphery of the substrates may be sandwiched and fixed by metallic flames, and the substrates and the flames may be sealed with a sealant to seal the interior of the cell and. Further, flexible materials may be used for the cell, the substrate, the packing material or the sealant, to constructing the solar cell on a curved surface.

The super straight type solar cell module may be manufactured by the following steps of: placing cells, lead lines for connecting a sealant to the cells and a sealant for back surface on a front substrate sent out from a substrate-supplying apparatus while carrying the front substrate by a belt conveyer, etc.; placing a back substrate or a back cover thereon; and setting flames at the outer edge portion.

The substrate type solar cell may be manufactured by the following steps of: placing cells and lead lines for connecting the cells, a sealant, etc. on a substrate sent out from a substrate-supplying apparatus while carrying the substrate by a belt conveyer, etc.; placing a front cover thereon; and setting flames at the outer edge portion.

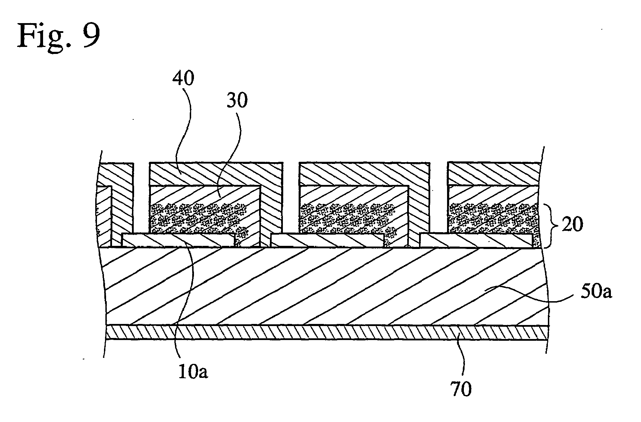

Fig. 9 shows a structure of an embodiment of the substrate-integrated type solar cell produced by modularizing a photoelectric conversion device of the present invention. The solar cell shown in Fig. 9 has a structure where cells having the transparent electrically conductive layer 10a, the photosensitive layer 20 containing dye-adsorbed TiO₂, the charge transfer layer 30 and the metal counter electrically conductive layer 40 are modularized on one surface of the transparent substrate 50a, the reflection-preventing layer 70 being disposed on the other surface of the transparent substrate 50a. In such a structure, it is preferable that the area ratio of the photosensitive layer 20 observed from the substrate 50a side is increased to enhance a utilizing efficiency of incident light.

As for the solar cell shown in Fig. 9, a desired module structure, in which the transparent electrically conductive layers, the photosensitive layers, the charge transfer layers and the counter electrodes etc. are three-dimensionally arranged at a regular interval on the substrate, can be obtained by patterning the layers, etc. accordingly to a semiconductor process technique such as selective metal plating, selective etching, CVD, PVD, etc., or a mechanical method such as laser scribing, plasma CVM, polishing, etc. The plasma CVM is described in Solar Energy Materials and Solar Cells, 48, p 373 to 381, etc.

Other materials and processes used in the solar cell comprising the photoelectric conversion device of the present invention will be described in detail below.

As a material for the sealant, various materials such as a liquid EVA (ethylene vinyl acetate), an EVA film, a mixture of fluorinated vinylidene copolymer and an acrylic resin, etc. may be used in accordance with objects such as application of weather-resistance or electric insulation, improvement in light-condensing efficiency, protection of a cell (improvement in impact resistance), etc. The outer edge of the module and the frame surrounding the module are preferably sealed with the sealant having high weather-resistance and moisture resistance. The strength and light transmittance of the sealed cell can be increased by adding a transparent filter into the sealant.

The sealant may be fixed to the cell by a method properly selected in accordance with a property of the sealant. For example, the film sealant may be fixed to the cell by roll pressurization followed by thermal adherence, vacuum pressurization followed by thermal adherence, etc., and the liquid or paste sealant may be fixed by roll coating, bar coating, spray coating, screen printing, etc.

The substrate is preferably made of a flexible material such as PET and PEN. In this case, the cells can be disposed on a substrate roll, and the sealant may be successively fixed to the cells, thereby improving productivity.

To increase electric power production efficiency, the light-taking surface of the substrate, which is generally tempered glass substrate, may be subjected to a reflection-preventing treatment. The reflection-preventing treatment may be achieved by laminating a reflection-preventing film, coating a reflection-preventing layer, etc.

The surface of the cell may be grooved or textured. This improves incident light-utilizing efficiency of the cell.

To increase the electric power production efficiency, it is important that light is taken into the module without loss, and additionally, that light reached to the inside of the solar cell through a photosensitive layer is effectively reflected and returned to the photosensitive layer. The light reflectance may be increased by: mirror plane-polishing the substrate and vapor-depositing or metal-plating the substrate with Ag, Al, etc.; disposing a reflective layer of an Al-Mg alloy, an Al-Ti alloy, etc. on the substrate; making a texture structure on the substrate by annealing.

To increase the electric power production efficiency, it is also important that the resistance of connection between the cells is lowered to prevent reduction in an inner voltage. The cells are generally connected each other by a wire bonding or an electrically conductive flexible sheet. The cells may be electrically connected while fixing the cells by an electrically conductive adhesives, adhesive tapes, etc., and may be connected by pattern-coating an electrically conductive hot melt.

A flexible solar cell may be produced by a method comprising the steps of: disposing the cells on the flexible substrate made of a polymer film, etc. in the same manner as described above while sending out a roll-like substrate; cutting the substrate to an intended size; and sealing the marginal portion thereof with a flexible, moisture resistant material. The solar cell may have a module structure called "SCAF" described in Solar Energy Materials and Solar Cells, 48, p 383 to 391. Further, the solar cell using the flexible substrate may be adhered and fixed to a curved glass, etc.

As described above in detail, the solar cell comprising the photoelectric conversion device of the present invention may have various forms and functions, which is selected in accordance with its ends and environment of use.

### EXAMPLES

The present invention will be explained in more detail with reference to examples below. The present invention is not restricted by these examples.

### 1. Syntheses of Compound Represented by General Formula (1)

The compounds represented by the general formula (1) were synthesized using the compounds **a** and **b** shown below. The structure of product was identified by ¹H-NMR.

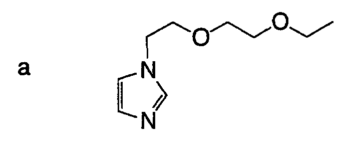

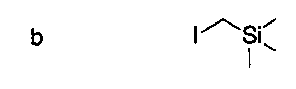

### (A) Synthesis of Compound 1-a

3.68 g (0.02 mol) of the compound **a** was mixed and made to react with 4.71 g (0.022 mol) of the compound **b**. After 3 hours of reaction at 110 ° C, the resultant mixture was heated under a reduced pressure, whereby the residual compound **b** was distilled off therefrom, to substantially quantitatively obtain the compound 1-a.

### (B) Synthesis of Compound 1-b

3.98 g (0.01 mol) of the compound 1-a and 2.87 g (0.01 mol) of *N-*lithiotrifluoromethane sulfonimide were added to 30 ml of water, and stirred for 30 minutes at room temperature. Then, the reaction mixture was extracted with methylene chloride, and the resultant methylene chloride solution was concentrated and dried for 5 hours under the condition of 80 ° C and 1 mmHg to obtain 4.1 g of the compound 1-b as oil.

### (C) Synthesis of Compound 1-c

3.98 g (0.01 mol) of the compound 1-a and 1.95 g (0.01 mol) of silver tetrafluoroborate were mixed in 25 ml of water. Then, the resultant solution was filtered through a celite to eliminate precipitates, and concentrated to remove water, followed by drying for 5 hours under the condition of 80 ° C and 1 mmHg to obtain 2.86 g of the compound 1-c as oil.

### (D) Synthesis of Compound 1-d

2.5 g of the compound 1-d was obtained as oil, in the same manner as synthesis of the compound 1-c except that 1.66 g of silver thiocyanate was used instead of 1.95 g of silver tetrafluoroborate.

### (E) Synthesis of Compound 1-e

3.0 g of the compound 1-e was obtained as oil, in the same manner as synthesis of the compound 1-c except that 2.20 g of silver trifluoroacetate was used instead of 1.95 g of silver tetrafluoroborate.

### (F) Synthesis of Compound 1-f

2.83 g of the compound 1-f was obtained as oil, in the same manner as synthesis of the compound 1-c except that 2.02 g of silver methanesulfonate was used instead of 1.95 g of silver tetrafluoroborate.

### (G) Syntheses of Others

The other compounds represented by the general formula (1) can be also easily synthesized by converting a heterocyclic compound into a corresponding quaternary ammonium compound in a similar method to above. Anion contained in the compound represented by the general formula (1) can be easily interchanged by the metathesis reaction mentioned above. Further, the compound represented by the general formula (1) may be purified by column chromatography using silica gel such as "WAKOGEL C-200" manufactured by Wako Pure Chemical Industries, Ltd., modified polysaccharide such as "Sephadex LH-20" and "Sephadex LH-60" manufactured by Pharmacia Corporation, etc., if necessary.

### 2. Production of Photo-Electrochemical Cell

### (A) Preparation of Titanium Dioxide Dispersion

A 200 ml inner volume of a stainless steel vessel coated with Teflon inside was charged with 15 g of titanium dioxide fine particles "Degussa P-25" manufactured by Nippon Aerosil K.K., 45 g of water, 1 g of dispersant "Triton X-100" manufactured by Aldrich, and 30 g of zirconia beads having a diameter of 0.5 mm manufactured by Nikkato K.K. These contents were subjected to a dispersion treatment for 2 hours at 1500 rpm by means of a sand-grinder mill manufactured by Imex K.K. The zirconia beads were removed by filtration to obtain the titanium dioxide dispersion. The average particle diameter of the titanium dioxide particles in the dispersion was 2.5 µm. Incidentally, the particle diameter was measured by Master Sizer manufactured by MALVERN.

### (B) Preparation of Dye-Adsorbed TiO₂ Electrode

The above titanium dioxide dispersion was coated on an electrically conductive surface of a conductive glass having a fluorine-doped tin oxide layer by a glass bar. Used as the conductive glass was 20 mm × 20 mm of "TCO Glass-U" manufactured by Asahi Glass K.K. with a surface resistance of approximately 30 Ω/square. A coating amount of the semiconductor fine particles was 20 g/m². Herein, on the eight glasses were coated the titanium dioxide dispersion at once after adhesive tape was attached to a part of the conductive surface (3 mm from the edge) of each conductive glass as a spacer, and the glasses were arranged so that the adhesive tapes come to both edges thereof. The coated glass was air-dried for a day at a room temperature after peeling the adhesive tapes.

Then, the glass was placed in an electric furnace "muffle furnace FP-32" manufactured by Yamato Science K.K., followed by calcinating at 450 ° C for 30 minutes to obtain TiO₂ electrode. After the TiO₂ electrode was taken out of the furnace and cooled, the electrode was immersed in an ethanol solution comprising the dye shown in Table 1 for 3 hours to adsorbing the dye. The concentration of the dye in the ethanol solution was 3×10⁻⁴ mol/l. The dye-adsorbed TiO₂ electrode was further immersed in 4-*t*-butylpyridine for 15 minutes, then washed with ethanol and air-dried. The thickness of thus-obtained photosensitive layer was shown in Table 1, and an adsorbing amount of the dye was appropriately selected in a range of 0.1 to 10 mmol/m² according to the dye.

### (C) Production of Photo-Electrochemical Cell

The 20 mm × 20 mm in size of the glass substrate containing a dye-sensitized TiO₂ prepared as described above was put on a platinum-vapor deposited glass having the same size. Next, an electrolyte composition was permeated into a crevice between the glasses through capillarity and was introduced into the TiO₂ electrode, to obtain a photo-electrochemical cell. According to this example, the photo-electrochemical cell similar to that shown in Fig. 1 was prepared, where the conductive support of the electrically conductive glass comprising the transparent substrate 50a of glass and the electrically conductive layer 10a disposed thereon; the photosensitive layer 20 of the dye-sensitized TiO₂; the charge transfer layer 30; the counter electrically conductive layer 40 of platinum; and the transparent substrate 50a of glass were laminated in this order, and sealed with an epoxy-based sealant. Incidentally, in the case where the electrolyte composition has a high viscosity, whereby it is difficult to permeating it through capillarity, the photo-electrochemical cell was produced by the method comprising the steps of: warming the electrolyte composition to 50 ° C; applying it on the TiO₂ electrode; sufficiently permeating the electrolyte composition into the electrode and removing air in the electrode under reduced pressure; and putting a platinum-deposited counter electrode glass thereon.

The above processes were repeatedly carried out while changing the electrolyte composition and the dye as shown in Table 1 to produce the photo-electrochemical cell of EXAMPLES 1 to 21 and COMPARATIVE EXAMPLES 1 to 9. The constitution of the electrolyte composition and the thickness of the photosensitive layer of each photo-electrochemical cell are shown in Table 1. The dye(s) used in each cell is also shown therein. In the Table 1, "BCE" represents bis(cyanoethyl) ether. Further, the structure of compounds Y-1 to Y-7 used in the EXAMPLES and COMPARATIVE EXAMPLES will be illustrated below.

**Table 1.**

| Photo-Electrochemical Cell | Electrolyte Composition Comprising 2 weight % of lodine | | Thickness of Photosensitive Layer µm | Dye (Mole Absorption Coefficient in DMF) |
|---|---|---|---|---|
| | Electrolyte Salt (weight %) | Solvent (weight %) | | |
| Comp. Ex. 1 | Y-1(10) | BCE(88) | 6.5 | R-1(14000) |
| Comp. Ex. 2 | Y-2(10) | BCE(88) | 6.5 | R-1(14000) |
| Comp. Ex. 3 | Y-1 (10) / Y-3(58) | BCE(30) | 6.5 | R-1(14000) |
| Comp. Ex. 4 | Y-1 (10) / Y-3(78) | BCE(10) | 6.5 | R-1(14000) |
| Ex. 1 | 1-a(10) | BCE(88) | 6.5 | R-1(14000) |
| Ex. 2 | 4-a(10) | BCE(88) | 6.5 | R-1(14000) |
| Ex. 3 | 1-a(10) /Y-3(58) | BCE(30) | 6.5 | R-1(14000) |
| Ex. 4 | 1-a(10) / Y-3(78) | BCE(10) | 6.5 | R-1(14000) |
| Comp. Ex. 5 | Y-1 (70) / Y-3(28) | - | 6.5 | R-1(14000) |
| Comp. Ex. 6 | Y-1 (70) / Y-4(28) | - | 6.5 | R-1(14000) |
| Comp. Ex. 7 | Y-1 (70) / Y-5(28) | - | 6.5 | R-1(14000) |
| Comp. Ex. 8 | Y-1 (70) / Y-6(28) | - | 6.5 | R-1(14000) |
| Comp. Ex. 9 | Y-1 (70) / Y-7(28) | - | 6.5 | R-1(14000) |
| Ex.5 | 1-a(70) / Y-3(28) | - | 6.5 | R-1(14000) |
| Ex. 6 | 1-a(70) / Y-4(28) | - | 6.5 | R-1(14000) |
| Ex.7 | 1-a(70) / Y-5(28) | - | 6.5 | R-1(14000) |
| Ex.8 | 1-a(70) / Y-6(28) | - | 6.5 | R-1(14000) |
| Ex. 9 | 1-a(70) / Y-7(28) | - | 6.5 | R-1(14000) |
| Ex. 10 | 1-a(70) / 1-c(28) | - | 6.5 | R-1(14000) |
| Ex. 11 | 1-a(70) / 1-d(28) | - | 6.5 | R-1(14000) |
| Ex. 12 | 1-a(70) / 1-e(28) | - | 6.5 | R-1(14000) |
| Ex. 13 | 1-a(70) / 1-f(28) | - | 6.5 | R-1(14000) |
| Ex. 14 | 2-a(70) / Y-4(28) | - | 6.5 | R-1(14000) |
| Ex. 15 | 2-a(70) / Y-5(28) | - | 6.5 | R-1(14000) |
| Ex. 16 | 2-a(70) / Y-6(28) | - | 6.5 | R-1(14000) |
| Ex. 17 | 6-a(70) / Y-4(28) | - | 6.5 | R-1(14000) |
| Ex. 18 | 10-a(70) / Y-4(28) | - | 6.5 | R-1(14000) |
| Ex. 19 | 12-a(70) / Y-4(28) | - | 6.5 | R-1(14000) |
| Ex. 20 | 14-a(70) / Y-4(28) | - | 6.5 | R-1(14000) |
| Ex. 21 | 1-a(50) / 10-a(20) / Y-4(28) | - | 6.5 | R-1(14000) |

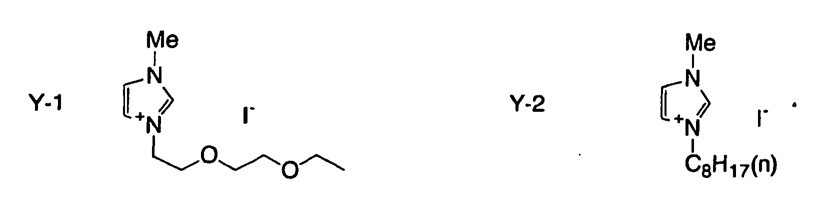

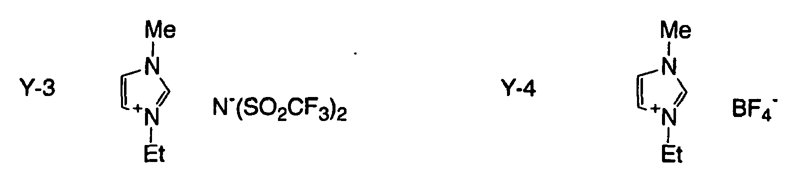

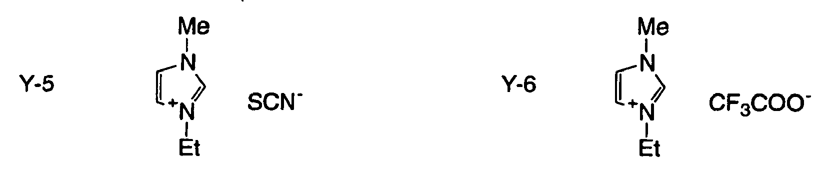

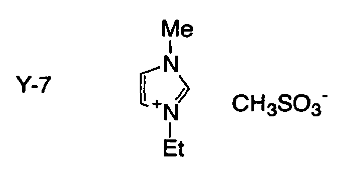

### 3. Measurement of Photoelectric Conversion Efficiency

A simulated sunlight was irradiated to the photo-electrochemical cells of EXAMPLES and COMPARATIVE EXAMPLES at 50 ° C, and the generated electricity was measured by the current-voltage tester "Keithley SMU238", to obtain open circuit voltage (Voc), short-circuit current density (Jsc), fill factor (FF), photoelectric conversion efficiency (η), and decrease (%) of short-circuit current density after storage in the dark for 80 hours with respect to each of the cells. The results are shown in Table 2. Incidentally, the simulated sunlight was obtained by passing the light of a 500 W xenon lamp manufactured by Ushio K.K. through an "AM 1.5 filter" manufactured by Oriel Co. and a sharp cut filter "Kenko L-42". The simulated sunlight was free of an ultraviolet radiation, and had intensity of 100 mW/cm².

**Table 2.**

| Photo-Electrochemical Cell | Open Circuit Voltage (Voc) V | Short-Circuit Current Density (Jsc) mA/cm² | Fill Factor (FF) | Photoelectric Conversion Efficiency (η) % | Decrease of Jsc after Storage for 80 hours % |
|---|---|---|---|---|---|
| Comp. Ex. 1 | 0.66 | 12.5 | 0.66 | 5.4 | 90 |
| Comp. Ex. 2 | 0.63 | 12.3 | 0.67 | 5.2 | 89 |
| Comp. Ex. 3 | 0.57 | 10.5 | 0.66 | 4.0 | 43 |
| Comp. Ex. 4 | 0.55 | 9.5 | 0.65 | 3.4 | 18 |
| Ex. 1 | 0.66 | 12.8 | 0.66 | 5.6 | 86 |
| Ex.2 | 0.64 | 12.6 | 0.66 | 5.3 | 85 |
| Ex. 3 | 0.57 | 11.3 | 0.65 | 4.2 | 18 |
| Ex. 4 | 0.55 | 10.0 | 0.65 | 3.6 | 9 |
| Comp. Ex. 5 | 0.50 | 8.0 | 0.65 | 2.6 | 6 |
| Comp. Ex. 6 | 0.55 | 8.6 | 0.66 | 3.1 | 5 |
| Comp. Ex. 7 | 0.55 | 8.9 | 0.66 | 3.2 | 5 |
| Comp. Ex. 8 | 0.57 | 8.4 | 0.65 | 3.1 | 5 |
| Comp. Ex. 9 | 0.56 | 8.3 | 0.65 | 3.0 | 6 |
| Ex. 5 | 0.51 | 9.0 | 0.65 | 3.0 | 5 |
| Ex. 6 | 0.57 | 9.1 | 0.65 | 3.4 | 4 |
| Ex.7 | 0.57 | 9.7 | 0.66 | 3.6 | 5 |
| Ex. 8 | 0.57 | 9.0 | 0.66 | 3.4 | 5 |
| Ex. 9 | 0.57 | 9.0 | 0.65 | 3.3 | 4 |
| Ex. 10 | 0.57 | 9.3 | 0.65 | 3.4 | 5 |
| Ex. 11 | 0.58 | 10.0 | 0.66 | 3.8 | 6 |
| Ex. 12 | 0.57 | 9.4 | 0.65 | 3.5 | 5 |
| Ex. 13 | 0.57 | 9.3 | 0.65 | 3.4 | 4 |
| Ex. 14 | 0.56 | 9.5 | 0.66 | 3.5 | 5 |
| Ex. 15 | 0.56 | 9.9 | 0.65 | 3.6 | 6 |
| Ex. 16 | 0.58 | 9.5 | 0.65 | 3.6 | 5 |
| Ex. 17 | 0.57 | 9.4 | 0.66 | 3.5 | 4 |
| Ex. 18 | 0.65 | 9.1 | 0.65 | 3.8 | 5 |
| Ex. 19 | 0.57 | 9.0 | 0.66 | 3.4 | 5 |
| Ex. 20 | 0.57 | 9.1 | 0.66 | 3.4 | 5 |
| Ex. 21 | 0.63 | 9.3 | 0.66 | 3.9 | 5 |

As shown in Table 2, although the photoelectric conversion properties of the cells using the electrolyte composition with a large amount of solvent were remarkably worsened during the storage, the cells according to EXAMPLES 1 to 4 exhibited improved photoelectric conversion efficiency and durability as compared with the cells of COMPARATIVE EXAMPLES 1 to 4 using prior art imidazolium salts. To suppress the decrease of the short-circuit current density during the storage to 10 % or less, the electrolyte composition preferably comprised 10 weight % or less of solvent, more preferably comprised no solvent.

On the other hand, in the case of the cells comprising the electrolyte composition with 0 to 10 weight % of solvent, the cells of COMPARATIVE EXAMPLES 4 to 9 using the conventional imidazolium salt exhibited a low short-circuit current density and photoelectric conversion efficiency. As compared with this, the cells according to the present invention of EXAMPLES 4 to 21 exhibited high short-circuit current density and improved conversion efficiency.

As explained above in detail, the electrolyte composition of the present invention is excellent in the durability and charge-transporting capability. The photoelectric conversion device comprising the electrolyte composition exhibits the excellent photoelectric conversion properties and less deterioration of the properties during the long-term use or storage. The photo-electrochemical cell composed of the device is remarkably useful as a solar cell.

## Claims

1. A photoelectric conversion device comprising a compound represented by the following general formula (1): 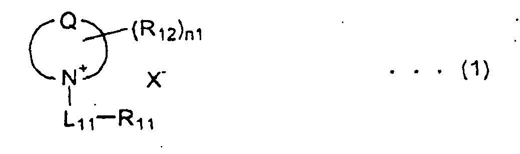 wherein Q represents an atomic group forming an aromatic cation having a 5-or 6-membered ring structure with a nitrogen atom; L₁₁ represents a divalent linking group selected from the group consisting of a substituted or unsubstituted alkylene group, a substituted or unsubstituted alkenylene group, a substituted or unsubstituted alkylenoxy group, a substituted or unsubstituted alkenylenoxy group, and a repetition or combination thereof; R₁₁ represents a hydrogen atom or a substituent; R₁₂ represents a substituent; n1 represents 0 or an integer of 1 to the maximum number of R₁₂ attachable to Q; X⁻ represents an anion; R₁₂'s may be the same or different groups when n1 is 2 or more; two or more of R₁₁ and R₁₂ may be bonded together to form a ring; and at least one of R₁₁ and R₁₂ contains a silicon atom.

2. The photoelectric conversion device according to claim 1, wherein said Q is composed of atoms selected from the group consisting of carbon, hydrogen, nitrogen, oxygen and sulfur atoms.

3. The photoelectric conversion device according to claim 1 or 2, wherein said aromatic cation formed by said Q is an imidazolium cation or a pyridinium cation.

4. The photoelectric conversion device according to any one of claims 1 to 3, wherein said compound represented by the general formula (1) is further represented by the following general formula (2): 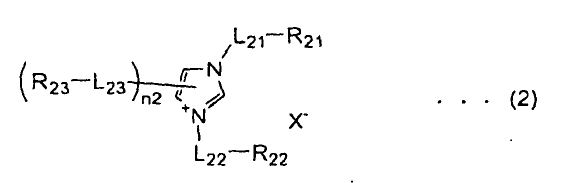 wherein L₂₁, L₂₂ and L₂₃ independently represent a divalent linking group selected from the group consisting of a substituted or unsubstituted alkylene group, a substituted or unsubstituted alkenylene group, a substituted or unsubstituted alkylenoxy group, a substituted or unsubstituted alkenylenoxy group, and a repetition or combination thereof; R₂₁, R₂₂ and R₂₃ independently represent a hydrogen atom or a substituent; n2 represents an integer of 0 to 3; X⁻ represents an anion; a plurality of L₂₃-R₂₃ may be the same or different groups when n2 is 2 or 3; two or more of R₂₁, R₂₂ and R₂₃ may be bonded together to form a ring; and at least one of R₂₁, R₂₂ and R₂₃ contains a silicon atom.

5. The photoelectric conversion device according to any one of claims 1 to 3, wherein said compound represented by the general formula (1) is further represented by the following general formula (3): 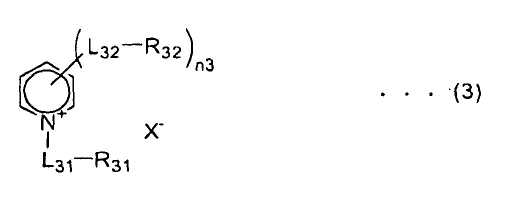 wherein L₃₁ and L₃₂ independently represent a divalent linking group selected from the group consisting of a substituted or unsubstituted alkylene group, a substituted or unsubstituted alkenylene group, a substituted or unsubstituted alkylenoxy group, a substituted or unsubstituted alkenylenoxy group, and a repetition or combination thereof; R₃₁ and R₃₂ independently represent a hydrogen atom or a substituent; n3 represents an integer of 0 to 5, X⁻ represents an anion; a plurality of L₃₂-R₃₂ may be the same or different groups when n3 is 2 or more; two or more of R₃₁ and R₃₂ may be bonded together to form a ring; and at least one of R₃₁ and R₃₂ contains a silicon atom.

6. The photoelectric conversion device according to any one of claims 1 to 5, wherein said X⁻ is I⁻,

7. The photoelectric conversion device according to any one of claims 1 to 6, comprising a solvent of 0 to 10 weight % based on the entire electrolyte composition.

8. The photoelectric conversion device according to any one of claims 1 to 7, comprising an iodine salt and/or iodine in addition to said compound represented by the general formula (1).

9. The photoelectric conversion device according to any one of claims 1-8, wherein said photosensitive layer comprises semiconductor fine particles sensitized by a dye.

10. The photoelectric conversion device according to claim 9, wherein said semiconductor fine particles are metal chalcogenide fine particles.

11. The photoelectric conversion device according to claim 10, wherein said metal chalcogenide fine particles contain titanium oxide fine particles.

12. The photoelectric conversion device according to any one of claims 9 to 11 wherein said dye is a metal complex dye and/or a polymethine dye.

13. A photo-electrochemical cell composed of said photoelectric conversion device recited in any one of claims 1 to 22.

14. An imidazolium compound represented by the following general formula (4): 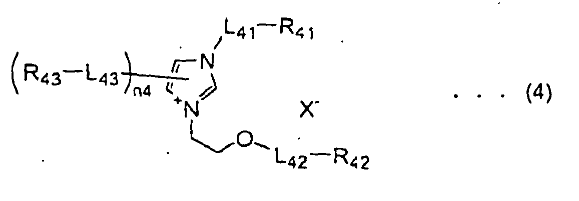 wherein L₄₁, L₄₂ and L₄₃ independently represent a divalent linking group selected from the group consisting of a substituted or unsubstituted alkylene group, a substituted or unsubstituted alkenylene group, a substituted or unsubstituted alkylenoxy group, a substituted or unsubstituted alkenylenoxy group, and a repetition or combination thereof; R₄₁, R₄₂ and R₄₃ independently represent a hydrogen atom, a halogen atom or a substituent selected from the group consisting of an alkyl group, an alkenyl group, an aryl group, a silyl group, a silyloxy group, an alkoxy group, an amino group, a guanidino group, a cyano group and a heterocyclic group, which may have another substituent; n4 represents an integer of 0 to 3; X⁻ represents an anion; a plurality of L₄₃-R₄₃ may be the same or different groups when n4 is 2 or 3;two or more of R₄₁, R₄₂ and R₄₃ may be bonded together to form a ring; and at least one of R₄₁, R₄₂ and R₄₃ contains a silicon atom.

## Patentansprüche

1. Photoelektrische Umwandlungsvorrichtung, umfassend eine Verbindung der allgemeinen Formel (1): 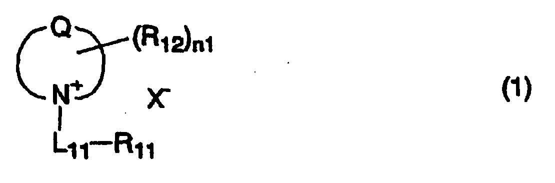 wobei Q eine Atomgruppe bedeutet, welche ein aromatisches Kation mit einer 5- oder 6-gliedrigen Ringstruktur mit einem Stickstoffatom bildet;
L₁₁ für eine bifunktionelle Verknüpfungsgruppe steht, gewählt aus der Gruppe, bestehend aus einer substituierten oder unsubstituierten Alkylengruppe, einer substituierten oder unsubstituierten Alkenylengruppe, einer substituierten oder unsubstituierten Alkylenoxygruppe, einer substituierten oder unsubstituierten Alkenylenoxygruppe und einer Wiederholung oder Kombination davon;
R₁₁ für ein Wasserstoffatom oder einen Substituenten steht; R₁₂ für einen Substituenten steht; n1 für 0 oder eine ganze Zahl von 1 bis zur maximal an Q anzulagernden Zahl von R₁₂ steht;
X- für ein Anion steht;
R₁₂'s gleiche oder verschiedene Gruppen sein können, wenn n1 2 oder mehr ist; zwei oder mehr von R₁₁ und R₁₂ unter Ringbildung miteinander verknüpft sein können; und
wenigstens eines von R₁₁ und R₁₂ ein Siliziumatom enthält.

2. Photoelektrische Umwandlungsvorrichtung nach Anspruch 1, wobei Q aus Atomen zusammengesetzt ist, gewählt aus der Gruppe, bestehend aus Kohlenstoff-, Wasserstoff-, Stickstoff-, Sauerstoff- und Schwefelatomen.

3. Photoelektrische Umwandlungsvorrichtung nach Anspruch 1 oder 2, wobei das von Q gebildete aromatische Kation ein Imidazoliumkation oder ein Pyridiniumkation ist.

4. Photoelektrische Umwandlungsvorrichtung nach einem der Ansprüche 1 bis 3, wobei die Verbindung mit der allgemeinen Formel (1) weiterhin durch die nachstehende allgemeine Formel (2) repräsentiert wird: 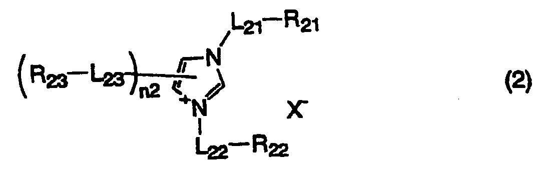 wobei L₂₁, L₂₂ und L₂₃ unabhängig für eine bifunktionelle Verknüpfungsgruppe stehen, gewählt aus der Gruppe, bestehend aus einer substituierten oder unsubstituierten Alkylengruppe, einer substituierten oder unsubstituierten Alkenylengruppe, einer substituierten oder unsubstituierten Alkylenoxygruppe, einer substituierten oder unsubstituierten Alkenylenoxygruppe und einer Wiederholung oder Kombination davon;
R₂₁, R₂₂ und R₂₃ unabhängig für ein Wasserstoff oder einen Substituenten stehen; n2 für eine ganze Zahl von 0 bis 3 steht;
X⁻ für ein Anion steht;
mehrere L₂₃-R₂₃ gleiche oder verschiedene Gruppen sein können, wenn n2 2 oder 3 ist; zwei oder mehrere von R₂₁, R₂₂ und R₂₃ unter Ringbildung miteinander verknüpft sein können; und
wenigstens eines von R₂₁, R₂₂ und R₂₃ ein Siliziumatom enthält.

5. Photoelektrische Umwandlungsvorrichtung nach einem der Ansprüche 1 bis 3, wobei die Verbindung mit der allgemeinen Formel (1) weiterhin durch die nachstehende allgemeine Formel (3) repräsentiert wird: 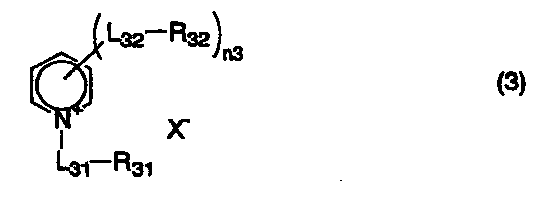 wobei L₃₁ und L₃₂ unabhängig für eine bifunktionelle Verknüpfungsgruppe stehen, gewählt aus der Gruppe, bestehend aus einer substituierten oder unsubstituierten Alkylengruppe, einer substituierten oder unsubstituierten Alkenylengruppe, einer substituierten oder unsubstituierten Alkylenoxygruppe, einer substituierten oder unsubstituierten Alkenylenoxygruppe und einer Wiederholung oder Kombination davon;
R₃₁ und R₃₂ unabhängig für ein Wasserstoff oder einen Substituenten stehen; n3 für eine ganze Zahl von 0 bis 5 steht;
X- für ein Anion steht;
mehrere L₃₂-R₃₂ gleiche oder verschiedene Gruppen sein können, wenn n3 2 oder mehr ist; zwei oder mehrere von R₃₁ und R₃₂ unter Ringbildung miteinander verknüpft sein können; und
wenigstens eines von R₃₁ und R₃₂ ein Siliziumatom enthält.

6. Photoelektrische Umwandlungsvorrichtung nach einem der Ansprüche 1 bis 5, wobei X- für I⁻ steht.

7. Photoelektrische Umwandlungsvorrichtung nach einem der Ansprüche 1 bis 6, umfassend 0 bis 10 Gew.-% eines Lösungsmittels, bezogen auf die gesamte Elektrolytzusammensetzung.

8. Photoelektrische Umwandlungsvorrichtung nach einem der Ansprüche 1 bis 7, umfassend ein lodsalz und/oder lod, zusätzlich zur Verbindung der allgemeinen Formel (1).

9. Photoelektrische Umwandlungsvorrichtung nach einem der Ansprüche 1 bis 8, wobei die lichtempfindliche Schicht mit Farbstoff sensibilisierte feine Halbleiterteilchen umfasst.

10. Photoelektrische Umwandlungsvorrichtung nach Anspruch 9, wobei die feinen Halbleiterteilchen feine Metallchalkogenidteilchen sind.

11. Photoelektrische Umwandlungsvorrichtung nach Anspruch 10, wobei die feinen Metallchalkogenidteilchen feine Titandioxidteilchen enthalten.

12. Photoelektrische Umwandlungsvorrichtung nach einem der Ansprüche 1 bis 11, wobei der Farbstoff ein Metallkomplexfarbstoff und/oder ein Polymethinfarbstoff ist.

13. Elektrochemische Photozelle, umfassend die photoelektrische Umwandlungsvorrichtung gemäß einem der Ansprüche 1 bis 12.

14. Imidazoliumverbindung der nachstehenden allgemeinen Formel (4): 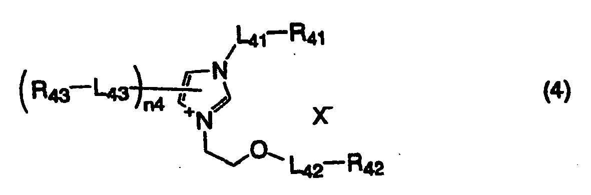 wobei L₄₁, L₄₂ und L₄₃ unabhängig für eine bifunktionelle Verknüpfungsgruppe stehen, gewählt aus der Gruppe, bestehend aus einer substituierten oder unsubstituierten Alkylengruppe, einer substituierten oder unsubstituierten Alkenylengruppe, einer substituierten oder unsubstituierten Alkylenoxygruppe, einer substituierten oder unsubstituierten Alkenylenoxygruppe und einer Wiederholung oder Kombination davon;
R₄₁, R₄₂ und R₄₃ unabhängig für ein Wasserstoffatom, ein Halogenatom oder einen Substituenten stehen, gewählt aus der Gruppe, bestehend aus einer Alkylgruppe, einer Alkenylgruppe, einer Arylgruppe, einer Silylgruppe, einer Silyloxygruppe, einer Alkoxygruppe, einer Aminogruppe, einer Guanidinogruppe, einer Cyanogruppe und einer heterocyclischen Gruppe, welche einen andren Substituenten tragen kann; n4 für eine ganze Zahl von 0 bis 3 steht;
X⁻ für ein Anion steht;
mehrere L₄₃-R₄₃ gleiche oder verschiedene Gruppen sein können, wenn n4 2 oder 3 ist; zwei oder mehrere von R₄₁, R₄₂ und R₄₃ unter Ringbildung miteinander verknüpft sein können; und
wenigstens eines von R₄₁, R₄₂ und R₄₃ ein Siliziumatom enthält.

## Revendications

1. Dispositif de conversion photoélectrique comprenant un composé représenté par la formule générale (1) suivante : 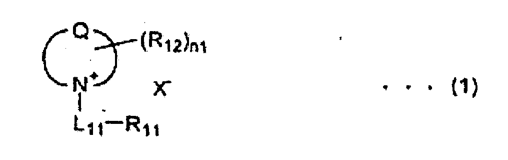 dans laquelle Q représente un groupe atomique formant un cation aromatique possédant une structure cyclique à 5 à 6 chaînons avec un atome d'azote ; L₁₁ représente un groupe de liaison divalent choisi dans le groupe constitué par un groupe alkylène substitué ou non substitué, un groupe alcénylène substitué ou non substitué, un groupe alkylènoxy substitué ou non substitué, un groupe alcénylènoxy substitué ou non substitué, et leur répétition ou leur combinaison ; R₁₁ représente un atome d'hydrogène ou un substituant ; R₁₂ représente un substituant ; n1 représente 0 ou un entier de 1 au nombre maximum de R₁₂ pouvant être fixés à Q ; X⁻ représente un anion ; les R₁₂ peuvent être des groupes identiques ou différents quand n1 est supérieur ou égal à 2 ; deux ou plusieurs R₁₁ et R₁₂ peuvent être liés ensemble pour former un cycle ; et au moins un parmi R₁₁ et R₁₂ contient un atome de silicium.

2. Dispositif de conversion photoélectrique selon la revendication 1, dans lequel ledit Q est composé d'atomes choisis dans le groupe constitué par les atomes de carbone, d'hydrogène, d'azote, d'oxygène et de soufre.

3. Dispositif de conversion photoélectrique selon la revendication 1 ou 2, dans lequel ledit cation aromatique formé par ledit Q est un cation imidazolium ou un cation pyridinium.

4. Dispositif de conversion photoélectrique selon l'une quelconque des revendications 1 à 3, dans lequel ledit composé représenté par la formule générale (1) est en outre représenté par la formule générale (2) suivante : 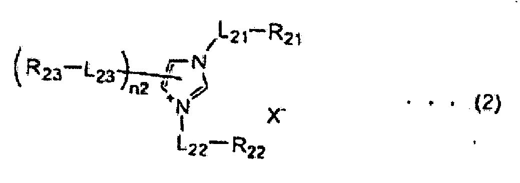 dans laquelle L₂₁, L₂₂ et L₂₃ représentent indépendamment un groupe de liaison divalent choisi dans le groupe constitué par un groupe alkylène substitué ou non substitué, un groupe alcénylène substitué ou non substitué, un groupe alkylènoxy substitué ou non substitué, un groupe alcénylènoxy substitué ou non substitué, et leur répétition ou leur combinaison ; R₂₁, R₂₂ et R₂₃ représentent indépendamment un atome d'hydrogène ou un substituant ; n2 représente un entier de 0 à 3 ; X⁻ représente un anion ; une pluralité de L₂₃-R₂₃ peut être des groupes identiques ou différents quand n2 est 2 ou 3 ; deux ou plusieurs R₂₁, R₂₂ et R₂₃ peuvent être liés ensemble pour former un cycle ; et au moins un parmi R₂₁, R₂₂ et R₂₃ contient un atome de silicium.

5. Dispositif de conversion photoélectrique selon l'une quelconque des revendications 1 à 3, dans lequel ledit composé représenté par la formule générale (1) est en outre représenté par la formule générale (3) suivante : 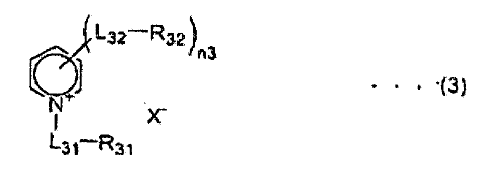 dans laquelle L₃₁ et L₃₂ représentent indépendamment un groupe de liaison divalent choisi dans le groupe constitué par un groupe alkylène substitué ou non substitué, un groupe alcénylène substitué ou non substitué, un groupe alkylènoxy substitué ou non substitué, un groupe alcénylènoxy substitué ou non substitué, et leur répétition ou leur combinaison ; R₃₁ et R₃₂ représentent indépendamment un atome d'hydrogène ou un substituant ; n3 représente un entier de 0 à 5, X⁻ représente un anion ; une pluralité de L₃₂-R₃₂ peut être des groupes identiques ou différents quand n3 est supérieur ou égal à 2 ; deux ou plusieurs R₃₁ et R₃₂ peuvent être liés ensemble pour former un cycle ; et au moins un parmi R₃₁ et R₃₂ contient un atome de silicium.

6. Dispositif de conversion photoélectrique selon l'une quelconque des revendications 1 à 5, dans lequel ledit X⁻ est I⁻.

7. Dispositif de conversion photoélectrique selon l'une quelconque des revendications 1 à 6, comprenant un solvant en une quantité de 0 à 10 % en poids en se basant sur la composition d'électrolyte totale.

8. Dispositif de conversion photoélectrique selon l'une quelconque des revendications 1 à 7, comprenant un sel d'iode et/ou un iode en plus dudit composé représenté par la formule générale (1).

9. Dispositif de conversion photoélectrique selon l'une quelconque des revendications 1 à 8, dans lequel ladite couche photosensible comprend de fines particules de semi-conducteur sensibilisées par un colorant.

10. Dispositif de conversion photoélectrique selon la revendication 9, dans lequel lesdites fines particules de semi-conducteur sont de fines particules de chalcogénure métallique.

11. Dispositif de conversion photoélectrique selon la revendication 10, dans lequel lesdites fines particules de chalcogénure métallique contiennent de fines particules d'oxyde de titane.

12. Dispositif de conversion photoélectrique selon l'une quelconque des revendications 9 à 11, dans lequel ledit colorant est un colorant de complexe métallique et/ou un colorant polyméthine.

13. Cellule photoélectrochimique composée dudit dispositif de conversion photoélectrique selon l'une quelconque des revendications 1 à 12.

14. Composé d'imidazolium représenté par la formule (4) générale suivante : 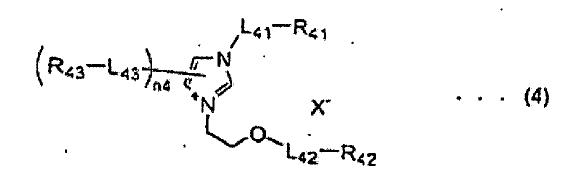 dans laquelle L₄₁, L₄₂ et L₄₃ représentent indépendamment un groupe de liaison divalent choisi dans le groupe constitué par un groupe alkylène substitué ou non substitué, un groupe alcénylène substitué ou non substitué, un groupe alkylènoxy substitué ou non substitué, un groupe alcénylènoxy substitué ou non substitué, et leur répétition ou leur combinaison ; R₄₁, R₄₂ et R₄₃ représentent indépendamment un atome d'hydrogène, un atome d'halogène ou un substituant choisi dans le groupe constitué par un groupe alkyle, un groupe alcényle, un groupe aryle, un groupe silyle, un groupe silyloxy, un groupe alcoxy, un groupe amino, un groupe guanidino, un groupe cyano et un groupe hétérocyclique, pouvant posséder un autre substituant ; n4 représente un entier de 0 à 3 ; X⁻ représente un anion ; une pluralité de L₄₃-R₄₃ peut être des groupes identiques ou différents quand n4 est 2 ou 3 ; deux ou plusieurs R₄₁, R₄₂ et R₄₃ peuvent être liés ensemble pour former un cycle ; et au moins un parmi R₄₁, R₄₂ et R₄₃ contient un atome de silicium.
